# EUROPEAN PATENT APPLICATION

(11) **EP 4 753 415 A1**
(43) Date of publication of application: **03.06.2026**
(21) Application number: 25204397.1
(22) Date of filing: 24.09.2025
(51) Int. Cl.: H10H 29/41, H10H 29/39

(54) **DISPLAY PANEL AND DISPLAY APPARATUS**

(30) Priority: 01.11.2024 CN 202411553836
(71) Applicant: Tianma Advanced Display Technology Institute (Xiamen) Co., Ltd., 361101 Xiamen (CN)
(72) Inventor: YANG, Bo, Xiamen, 361101 (CN); JIA, Zhenyu, Xiamen, 361101 (CN)
(74) Representative: Boult Wade Tennant LLP

(57) **Abstract**

The present application provides a display panel and a display apparatus. The display panel comprises a plurality of pixel circuits, each of which comprises a plurality of transistors. The display panel further comprises a substrate, a first organic layer, and a first metal layer. The first organic layer is disposed on one side of the substrate, the first metal layer is disposed on the side of the first organic layer away from the substrate, the first metal layer comprises a first conductor portion, and orthographic projections of the first conductor portion and at least one of the transistors in the pixel circuit on the substrate overlap. The first conductor portion comprises a first opening, and an orthographic projection of the first opening on the substrate overlaps at least partially with an orthographic projection of the first organic layer on the substrate.

## Description

### TECHNICAL FIELD

The present application relates to the technical field of display devices, in particular to a display panel and a display apparatus.

### BACKGROUND

With the development of science and technology, the field of display panels has made a tremendous progress and achieved diversified development. On this basis, people's requirements for display panels are increasing day by day. How to improve the reliability of display panels while meeting performance needs has become one of the research directions for manufacturers.

### SUMMARY

Embodiments of the present application provide a display panel and a display apparatus to improve the reliability of the display panel.

In a first aspect, embodiments of the present application provides a display panel, the display panel includes pixel circuits which include a plurality of transistors; the display panel further includes a substrate, a first organic layer, and a first metal layer; the first organic layer is disposed on one side of the substrate, the first metal layer is disposed on the side of the first organic layer away from the substrate, the first metal layer includes a first conductor portion, and orthographic projections of the first conductor portion and at least one of the transistors in the pixel circuit on the substrate overlap. The first conductor portion includes a first opening, and an orthographic projection of the first opening on the substrate overlaps at least partially with an orthographic projection of the first organic layer on the substrate.

In a second aspect, embodiments of the present application provide a display apparatus including a display panel, the display panel includes pixel circuits which include a plurality of transistors; the display panel further includes a substrate, a first organic layer, and a first metal layer; the first organic layer is disposed on one side of the substrate, the first metal layer is disposed on the side of the first organic layer away from the substrate, the first metal layer includes a first conductor portion, and orthographic projections of the first conductor portion and at least one of the transistors in the pixel circuit on the substrate overlap. The first conductor portion includes a first opening, and an orthographic projection of the first opening on the substrate overlaps at least partially with an orthographic projection of the first organic layer on the substrate.

### BRIEF DESCRIPTION OF THE DRAWINGS

In order to explain the technical solutions of the embodiments of the present application more clearly, the accompanying drawings required for use in the embodiments of the present application will be briefly introduced below. Those of ordinary skill in the art can derive other drawings based on the accompanying drawings without any creative effort.
Fig. 1 is a cross-sectional structural view of a display panel provided in an embodiment of the present application;
Fig. 2 is a cross-sectional structural view of a display panel provided in an embodiment of the present application in another region;
Fig. 3 is a simple arrangement view of pixel circuits provided in an embodiment of the present application;
Fig. 4A and Fig. 4B are simple views of two types of pixel circuits in a display panel provided in an embodiment of the present application;
Fig. 5 is a cross-sectional structural view of another display panel provided in an embodiment of the present application;
Fig. 6A and Fig. 6B are schematic structural views of a first metal layer in another display panel provided in an embodiment of the present application;
Fig. 7 is a simple arrangement view of circuits in another display panel provided in an embodiment of the present application;
Fig. 8 is a cross-sectional structural view of still another display panel provided in an embodiment of the present application;
Fig. 9 is a cross-sectional structural view of still another display panel provided in an embodiment of the present application;
Fig. 10 is a schematic structural view of partial pixel arrangement of still another display panel provided in an embodiment of the present application;
Fig. 11 is a cross-sectional structural view of still another display panel provided in an embodiment of the present application;
Fig. 12 is a cross-sectional structural view of still another display panel provided in an embodiment of the present application;
Fig. 13 is a cross-sectional structural view of still another display panel provided in an embodiment of the present application;
Fig. 14 is a schematic structural view of a second metal layer in still another display panel provided in an embodiment of the present application;
Fig. 15 is a schematic view showing a positional relationship between a first metal layer and a second metal layer in still another display panel provided in an embodiment of the present application;
Fig. 16 is a schematic view showing a positional relationship between a first metal layer and a first organic layer in still another display panel provided in an embodiment of the present application; and
Fig. 17 is a schematic structural view of a display apparatus provided in an embodiment of the present application.

### LIST OF REFERENCES:

100. Display panel; 200. Display apparatus;
10. Substrate;
20. First organic layer; 21. Exhaust hole;
30. First metal layer; 31. First conductor portion; 311. First sub portion; 312. Second sub portion; 313. Connecting portion; 32. First opening; 321. First type of opening; 322. Second type of opening; 33. Conductive portion;
41. First insulating layer; 42. Second insulating layer; 421. Second opening;
50. Second metal layer; 51. Second conductor portion; 52. Third type of opening; 53. Fourth type of opening; 54. First pad; 55. Second pad;
61. First active layer; 611. First active structure; 612. First exposed portion; 62. Second active layer; 621. Second active structure; 622. Second exposed portion;
P. Pixel circuit; P1. Pulse width modulation circuit; P2. Pulse amplitude modulation circuit; M. Transistor; C. Repeat circuit group; J. Spacer region; V. Shift register unit; F. Light emitting element;
X. First direction; Y. Second direction; Z. Thickness direction.

### DETAILED DESCRIPTION

Features and exemplary embodiments of various aspects of the present application will be described in detail below. In order to make the objectives, technical solutions, and advantages of the present application clearer, the present application will be further described in detail below with reference to the accompanying drawings and specific embodiments. It should be understood that the specific embodiments described here are only intended to explain the present application, but not to limit the present application. For those skilled in the art, the present application can be implemented without some of these specific details. The following descriptions of the embodiments are merely for providing a better understanding of the present invention by showing examples of the present invention.

It should be noted that the relational terms herein, such as first and second, are merely used for distinguishing one entity or operation from another, and do not necessarily require or imply that any actual relationship or sequence exists between these entities or operations. Moreover, the terms "include", "comprise", and any variants thereof are intended to cover a non-exclusive inclusion, so that a process, method, article, or device including a series of elements not only includes those elements, but further includes other elements not listed explicitly, or includes inherent elements of the process, method, article, or device. In the absence of more limitations, an element defined by "include a..." does not exclude other same elements existing in the process, method, article, or device including the element.

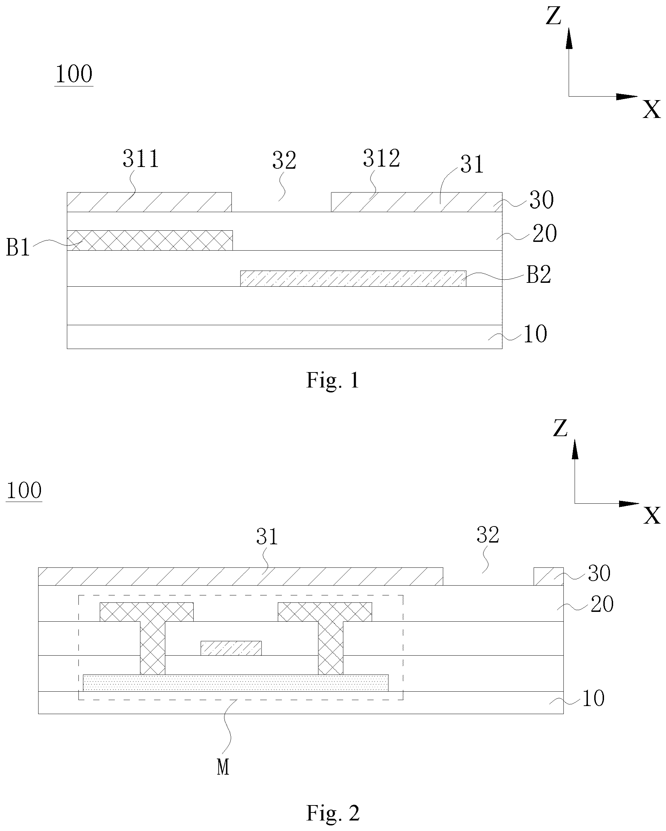

In a first aspect, with reference to Fig. 1 to Fig. 3, an embodiment of the present application provides a display panel 100. The display panel 100 includes a plurality of pixel circuits P, each of which includes a plurality of transistors M. The display panel 100 further includes a substrate 10, a first organic layer 20, and a first metal layer 30. The first organic layer 20 is disposed on one side of the substrate 10, the first metal layer 30 is disposed on the side of the first organic layer 20 away from the substrate 10, the first metal layer 30 includes a first conductor portion 31, and orthographic projections of the first conductor portion 31 and at least one of the transistors M in the pixel circuit P on the substrate 10 overlap. The first conductor portion 31 includes a first opening 32, and an orthographic projection of the first opening 32 on the substrate 10 overlaps at least partially with an orthographic projection of the first organic layer 20 on the substrate 10.

The display panel 100 is a device for displaying images. The display panel 100 may include light emitting elements. The light emitting elements are main components used for achieving a light emitting function. The light emitting elements may be micro light emitting diodes (Micro LEDs), mini light emitting diodes (Mini LEDs), or the like. The light emitting elements may have various structural forms, such as flip chips, horizontal chips, or vertical chips, which are not limited by the embodiments of the present application.

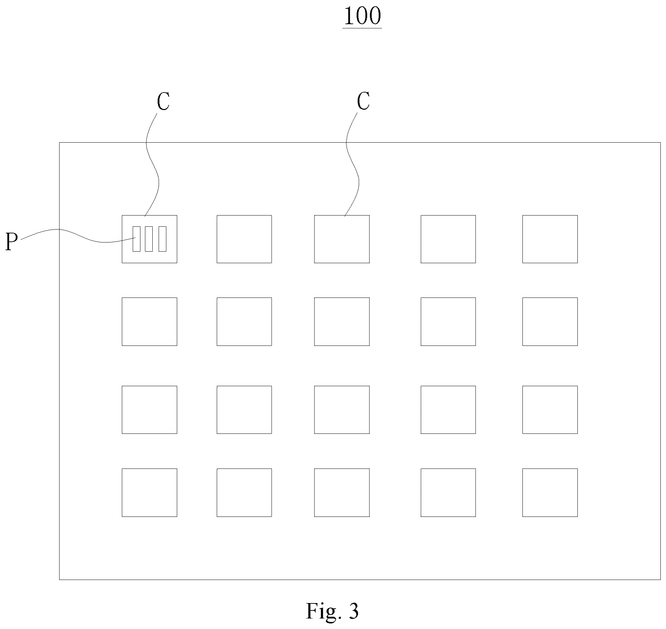

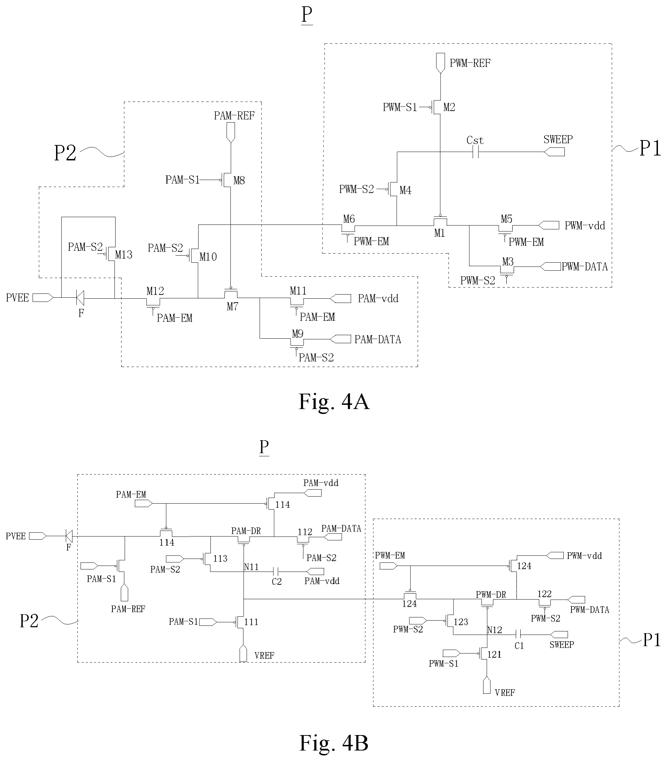

The pixel circuit P is a circuit used for driving and controlling light emission of the light emitting elements. There is a plurality of pixel circuits P, each of which controls different light emitting elements to achieve a light emitting function. Fig. 3 illustrates that a plurality of adjacent pixel circuits P jointly constitute a repeat circuit group C, and a plurality of repeat circuit groups C are arranged in an array in a plurality of directions. The pixel circuit P may include a plurality of device structures such as storage capacitors and transistors M. The specific form of the pixel circuit P is not limited by the embodiments of the present application. Optionally, refer to Fig. 4A and Fig. 4B. Fig. 4A and Fig. 4B show two different forms of pixel circuits P provided in an embodiment of the present application. In Fig. 4A and Fig. 4B, the pixel circuit P includes a pulse width modulation circuit P1 and a pulse amplitude modulation circuit P2, and each of the pulse width modulation circuit P1 and the pulse amplitude modulation circuit P2 includes a plurality of transistors M.

The substrate 10 is a film layer used for supporting in the display panel 100. Other film layer structures and device structures are sequentially stacked on the substrate 10. The stacking referred to here indicates that other film layer structures and device structures are sequentially arranged in a thickness direction Z of the substrate 10. The thickness direction Z of the substrate 10 is usually consistent with the thickness direction Z of other film layers. For ease of expression, the thickness direction Z of the substrate 10 and the thickness direction Z of other film layers are illustrated in the same direction subsequently in the embodiments of the present application.

The first metal layer 30 is a film layer disposed on one side of the substrate 10 and including a metal conductor material, the first metal layer 30 includes a first conductor portion 31, and the first conductor portion 31 may have various shapes and sizes. For example, the orthographic projection of the first conductor portion 31 on the substrate 10 may be a complete surface structure, or the first conductor portion 31 may include a plurality of sub portion structures, and the orthographic projection of the single sub portion structure on the substrate 10 may be a strip or block structure.

The first conductor portion 31 may be a conductor structure used for transmitting specific signals in the display panel 100. The specific type of signals transmitted by the first conductor portion 31 is not limited by the embodiments of the present application. Further, the conductor structures of the first conductor portions 31 in different regions may be used for transmitting the same potential voltage or different potential voltages.

Orthographic projections of the first conductor portion 31 and at least one of the transistors M in the pixel circuit P on the substrate 10 overlap at least partially. The expression "overlap at least partially" indicate that the orthographic projections of the first conductor portion 31 and at least one of the transistors M on the substrate 10 have an overlapping region, where the orthographic projection of the first conductor portion 31 on the substrate 10 may have an overlapping region with only one transistor M, or the orthographic projection of the first conductor portion 31 on the substrate 10 may have overlapping regions with a plurality of transistors M simultaneously.

The transistor M is usually composed of different structures located in different film layers. For example, the transistor M may include an active structure located in an active layer, a control terminal located in one of conductor layers, as well as a first electrode and a second electrode located in other conductor layers, where the control terminal is used for controlling conduction or disconnection between the first electrode and the second electrode. In such design, the first conductor portion 31 is used for transmitting specific signals to meet operational requirements of the display panel 100, and the first conductor portion 31 can also cover and shield the transistors M, thereby reducing the possibility that light emitted by the display panel 100 or ambient light irradiates the transistors M through refraction or reflection, reducing adverse effects of the light on the transistors M, and improving the operational reliability of the pixel circuit P.

In some optional embodiments, the size of the first conductor portion 31 in both a first direction X and a second direction is not less than 40 µm, where the first direction X, the second direction, and the thickness direction Z intersect each other. In this case, the first conductor portion 31 is of a large metal structure, which helps to improve the covering and shielding effect of the first conductor portion 31 on the transistors M, thereby further reducing the adverse effects of the light on the transistors M.

The first organic layer 20 is a film layer disposed on one side of the substrate 10 and including an organic material, and the first organic layer 20 is disposed between the substrate 10 and the first metal layer 30. The first organic layer 20 may be attached to the first metal layer 30, or the first organic layer 20 may be spaced apart from the first metal layer 30 in the thickness direction Z. The first organic layer 20 can not only insulate the first metal layer 30 from other conductive film layers located on the side of the first organic layer 20 facing the substrate 10, but also reduce parasitic capacitance formed between the first metal layer 30 and the other conductive film layers located on the side of the first organic layer 20 facing the substrate 10, thereby improving the performance and stability of circuit structures inside the display panel 100.

It should be noted that there may be various other film layer structures inside the display panel 100 in addition to the above-mentioned film layer structures. For example, as shown in Fig. 1, the side of the first organic layer 20 facing the substrate 10 may further include a first conductive functional layer B1 and a second conductive functional layer B2, the first conductive functional layer B1 and the second conductive functional layer B2 each include a conductor material, signal traces such as data lines and power signal lines may be provided in the first conductive functional layer B1, and signal traces such as scan lines and light emitting control lines may be provided in the second conductive functional layer B2. Alternatively, the first electrode and second electrode of the transistor M may be located in the first conductive functional layer B1, while the control terminal may be located in the second conductive functional layer B2.

In a production process of the display panel 100, the display panel 100 needs a plurality of film forming processes. During the production of the first organic layer 20, gases to be released, such as water vapor, may be trapped between the first organic layer 20 and other film layers on the side away from the substrate 10. On this basis, at the position where the first conductor portion 31 overlaps with the first organic layer 20, the first conductor portion 31 may hinder the release process of gases, making release of the gases more difficult. Especially for the first conductor portion 31 with a large projection area, for example, when the size of the first conductor portion 31 in each of the first direction X and the second direction is not less than 40 µm, the difficulty in gas release further increases. In this case, the display panel 100 is prone to bulging at local positions, and the first conductor portion 31 is prone to detachment, which affect the production yield and use reliability of the display panel 100.

In view of this, the structure of the first conductor portion 31 is adjusted in the embodiments of the present application, where the first opening 32 is added in the first conductor portion 31, the first opening 32 runs through the first conductor portion 31 in the thickness direction Z, and the orthographic projection of the first opening 32 on the substrate 10 overlaps at least partially with the orthographic projection of the first organic layer 20 on the substrate 10. In this case, at least some structures in the first organic layer 20 can be exposed relative to the first conductor portion 31 by means of the first opening 32. In the production process corresponding to the first conductor portion 31, water vapor and the like remaining in the first organic layer 20 can be released through the first opening 32, thereby reducing the risks of film bulging and detachment of the first conductor portion 31 caused by blocked water vapor and improving the production yield and use reliability of the display panel 100.

It should be noted that the size, shape, and quantity of the first opening 32 are not limited by the embodiments of the present application. One or a plurality of first openings 32 may be provided. When a plurality of first openings 32 are provided, the shape and size of different first openings 32 may be the same or different. For example, the orthographic projection of the first opening 32 on the substrate 10 may have a regular shape such as circular, triangular or square, or have an irregular shape, which is not limited by the embodiments of the present application.

The positional relationship between the first opening 32 and the transistor M is not limited by the embodiments of the present application. The orthographic projection of the first opening 32 on the substrate 10 may overlap with the orthographic projection of the transistor M on the substrate 10, or as shown in Fig. 2, not overlap with the orthographic projection of the transistor M on the substrate 10. Further, when a plurality of first openings 32 are provided, the orthographic projection of each first opening 32 on the substrate 10 may overlap with the orthographic projection of the transistor M on substrate 10, or the orthographic projection of each first opening 32 on the substrate 10 may not overlap with the orthographic projection of the transistor M on the substrate 10, or the orthographic projections of some of the first openings 32 on the substrate 10 overlap with the orthographic projections of the transistors M on the substrate 10, and the orthographic projections of the other first openings 32 on the substrate 10 do not overlap with the orthographic projections of the transistors M on the substrate 10.

In addition, the conductor structures of the first conductor portion 31 on different sides of the first opening 32 may be used for transmitting the same potential voltage or different potential voltages, that is, the conductor structures of the first conductor portion 31 on different sides of the first opening 32 may be used for transmitting different signals. Further, the conductor structures of the first conductor portion 31 on different sides of the first opening 32 may be connected into a whole or disconnected from each other.

In summary, in the embodiments of the present application, the first conductor portion 31 is used for transmitting specific signals to meet the operational requirements of the display panel 100, and can also cover and shield the transistors M, thereby reducing the possibility that light emitted by the display panel 100 or ambient light irradiates the transistors M through refraction or reflection, reducing adverse effects of the light on the transistors M, and improving the operational reliability of the pixel circuit P. On this basis, by adding the first opening 32 in the first conductor portion 31, water vapor and the like remaining in the first organic layer 20 can be released through the first opening 32, thereby reducing the risks of film bulging and detachment of the first conductor portion 31 caused by blocked water vapor and improving the production yield and use reliability of the display panel 100.

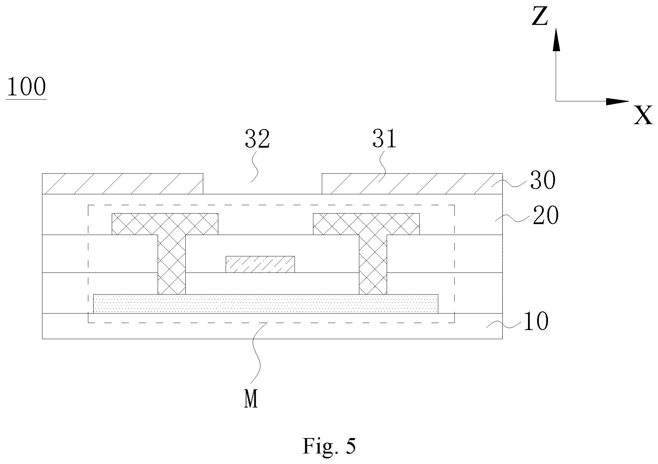

In some embodiments, with reference to Fig. 5, the orthographic projections of at least some of the first openings 32 on the substrate 10 overlap at least partially with the orthographic projections of the transistors M in the pixel circuit P on the substrate 10; additionally or alternatively as shown in Fig. 2, the orthographic projections of at least some of the first openings 32 on the substrate 10 are located outside the orthographic projection of each transistor M in the pixel circuit P on the substrate 10.

For the first openings 32, there may be a plurality of positional relationships between a single first opening 32 and a transistor M. When a plurality of first openings 32 are provided, the positional relationships between different first openings 32 and the transistors M may be the same or different. On this basis, according to different actual needs, the orthographic projections of some or all of the first openings 32 on the substrate 10 may overlap with the orthographic projections of the transistors M in the pixel circuit P on the substrate 10, or the orthographic projections of some or all of the first openings 32 on the substrate 10 may not overlap with the orthographic projections of the transistors M in the pixel circuit P on the substrate 10.

It should be noted that, when the orthographic projection of the single first opening 32 on the substrate 10 is located outside the orthographic projection of each transistor M in the pixel circuit P on the substrate 10, the orthographic projection of the first opening 32 on the substrate 10 may be located between the orthographic projections of the adjacent pixel circuits P on the substrate 10, or the orthographic projection of the first opening 32 on the substrate 10 may be located on the periphery of the orthographic projections of all the pixel circuits P on the substrate 10, or the orthographic projection of the first opening 32 on the substrate 10 may be located within the orthographic projection of the single pixel circuit P on the substrate 10 and is aligned with the orthographic projection of each transistor M on the substrate 10, which is not limited by the embodiments of the present application.

In the embodiments of the present application, there may be various positional relationships between the first opening 32 and the transistor M, and the positional relationships between different first openings 32 and transistors M may be the same or different. On this basis, by changing the quantity and relative position of the first opening 32, the adverse effects of light on the transistors M can be reduced, the water vapor release effect can be improved, and the risks of film bulging and detachment of the first conductor portion 31 can be reduced, with strong flexibility and practicality.

In some embodiments, with reference to Figs. 1, 2, 5, and 6a, the plurality of first openings 32 include a first type of openings 321 and a second type of openings 322, and the size of the first type of openings 321 is greater than that of the second type of openings 322.

A plurality of first openings 32 are provided, and the plurality of first openings 32 are spaced apart from each other, that is, the adjacent first openings 32 are spaced apart by a certain distance and distributed in different regions of the display panel 100, so as to meet exhaust requirements of the display panel 100 at different positions. The plurality of first openings 32 include a first type of openings 321 and a second type of openings 322, and the size of the first type of openings 321 is greater than that of the second type of openings 322. The term "size" mentioned here refers to orthographic projection area on the substrate 10, that is, the orthographic projection area of the first type of openings 321 on the substrate 10 is greater than that of the second type of openings 322 on the substrate 10.

Further, the first type of openings 321 refer to openings with corresponding orthographic projection area greater than a first preset value, while the second type of openings 322 refer to openings with corresponding orthographic projection area less than the first preset value. The specific magnitude of the first preset value is not limited by the embodiments of the present application. Optionally, the first preset value is 40 µm2. The quantity of the first type of openings 321 may be plural, and the shape and size of the first type of different openings 321 on the substrate 10 may be the same or different. Similarly, the quantity of the second type of openings 322 may be plural, and the shape and size of the second type of different openings 322 on the substrate 10 may be the same or different.

Optionally, the quantity of the first type of openings 321 is less than that of the second type of openings 322.

The positional relationship between the first type of openings 321 and the second type of openings 322 relative to the pixel circuit P is not limited by the embodiments of the present application. The orthographic projection of the first type of openings 321 on the substrate 10 may overlap or not overlap with the orthographic projection of the pixel circuit P on the substrate 10, and the positional relationship between the second type of openings 322 and the pixel circuit P is the same, which will not be repeated by the embodiments of the present application.

In the embodiments of the present application, for different requirements of the display panel 100 in different regions, the plurality of first openings 32 are configured to include a first type of openings 321 and a second type of openings 322 that have different sizes and spaced apart from each other, thereby further increasing the gas release effect at specific positions by means of the first type of openings 321 to improve the production yield. The second type of openings 322 can meet the gas release requirements and achieve a covering and shielding effect on lower film layer structures by means of the conductor structures on the periphery of the second type of openings 322 to improve the use performance of the display panel 100.

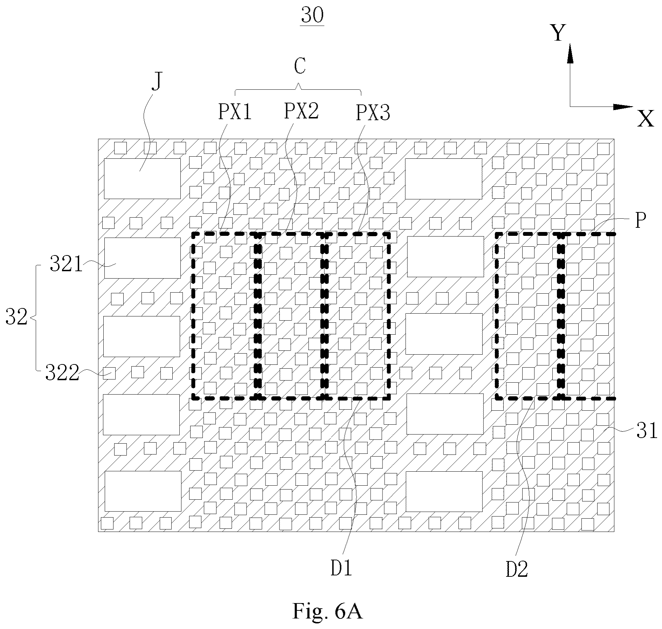

In some embodiments, as shown in Figs. 1, 2, 5, and 6a, on a plane perpendicular to the plane where the display panel is located 100, the first type of openings 321 do not overlap with the pixel circuit P; and on the plane perpendicular to the plane where the display panel 100 is located, at least some of the second type of openings 322 overlap with the pixel circuit P. In Fig. 6A, the pixel circuit P is shown in the form of a dashed box.

The direction perpendicular to the plane where the display panel 100 is located is the thickness direction Z. On this basis, the first type of openings 321 do not overlap with the pixel circuit P, that is, the orthographic projections of the first type of openings 321 on the substrate 10 are located outside the orthographic projection of the pixel circuit P on the substrate 10. At least some of the second type of openings 322 overlap with the pixel circuit P, that is, the orthographic projections of at least some of the second type of openings 322 on the substrate 10 have overlapping regions with the orthographic projection of the pixel circuit P on the substrate 10. When the second type of openings 322 is plural, all the second type of openings 322 may overlap with the pixel circuit P, or some of the second type of openings 322 may overlap with the pixel circuit P, and some of the second type of openings 322 may not overlap with the pixel circuit P.

In the embodiments of the present application, the first type of openings 321 has an opening structure with a large size. The first type of openings 321 does not overlap with the pixel circuit P, which can achieve an exhaust function outside the region where the pixel circuit P is located, improve the gas release effect, and reduce the risk of performance degradation caused by large-area exposure of the pixel circuit P to the first type of openings 321. For the second type of openings 322, at least some of the second type of openings 322 overlap with the pixel circuit P, so that the exhaust requirements at the region where the pixel circuit P is located can be met by means of the second type of openings 322. The second type of openings 322 have an opening structure with a small size, so the exposed area of the pixel circuit P at the second type of openings 322 is relatively small, which can reduce the degree of performance degradation of the pixel circuit P due to light irradiation and laser bonding and is conducive to improving the production yield and use effect of the display panel 100.

In some embodiments, the orthographic projection of the first type of opening 321 on the substrate 10 is located between the orthographic projections of the adjacent pixel circuits P on the substrate 10. In Fig. 6A, the plurality of pixel circuits P include first circuits D1 and second circuits D2, and some of the first type of openings 321 are located between the first circuits D1 and the second circuits D2.

In the embodiments of the present application, considering that at least some adjacent pixel circuits P may have a large spacing size, the first type of opening 321 is correspondingly disposed between adjacent pixel openings. Such design can improve the gas release capability of the first conductor portion 31 and reduce the risk of detachment of the first conductor portion 31 by means of the first type of openings 321. On the other hand, such design can also meet the requirements of the first type of openings 321 for avoidance of the pixel circuits P, thereby reducing the risk of performance degradation caused by the large-area exposure of the pixel circuits P to the first type of openings 321.

It should be noted that only one first type of opening 321 or a plurality of the first type of openings 321 may be disposed between the same two adjacent pixel circuits P, which is not limited by the embodiments of the present application. Optionally, a plurality of the first type of openings 321 may be disposed between two adjacent pixel circuits P in the first direction X, and the plurality of the first type of openings 321 may be spaced apart side by side in the second direction Y, where the first direction X, the second direction Y, and the thickness direction Z intersect each other.

In some embodiments, as shown in Figs. 1, 2, 5, and 6a, a plurality of adjacent pixel circuits P jointly form a repeat circuit group C, and a plurality of repeat circuit groups C are repeatedly arranged, where the adjacent repeat circuit groups C are spaced apart to form a spacer region J, and the first type of openings 321 are located in the spacer region J.

A plurality of repeat circuit groups C are provided in the display panel 100, and the structural layout of the pixel circuits P in each repeat circuit group C and the arrangement of different pixel circuits P are consistent. The plurality of repeat circuit groups C may be arranged in a single direction or in a plurality of directions. Optionally, as shown in Fig. 6A, a single repeat circuit group C includes a first pixel circuit PX1, a second pixel circuit PX2, and a third pixel circuit PX3 arranged side by side in the first direction X, and the plurality of repeat circuit groups C are arranged in the first direction X and the second direction Y respectively. The first circuit D1 is the third pixel circuit PX3 in the repeat circuit group C, while the second circuit DP2 is the first pixel circuit PX1 in another repeat circuit group C.

Further, the display panel 100 may include pixel units composed of a plurality of light emitting elements, and the pixel units are repeatedly arranged, where the pixel units correspond to the repeat circuit groups C, that is, the plurality of pixel circuits P in the single repeat circuit group C are used for driving the plurality of light emitting elements in the single pixel unit, and different pixel circuits P in different repeat circuit groups C are used for driving different light emitting elements in different pixel units.

In some optional embodiments, the arrangement of the plurality of pixel circuits P in the single repeat circuit group C is the same as that of the plurality of light emitting elements F in the single pixel unit, and the arrangement of the plurality of repeat circuit groups C is the same as that of the corresponding pixel units.

In the embodiments of the present application, the spacer region J is such a region that is located between the adjacent repeat circuit groups C and where no pixel circuit P is provided. Compared to the distance between the two adjacent pixel circuits P in the single repeat circuit group C, the distance between the two adjacent pixel circuits P in the adjacent repeat circuit groups C is often longer. On this basis, by disposing the first type of openings 321 in the spacer region J, the first type of openings 321 are located between the two adjacent pixel circuits P in the adjacent repeat circuit groups C. In this case, the first type of openings 321 avoid the pixel circuits P, and the first type of openings 321 has a relatively large size, thereby improving the gas release capability of the first conductor portion 31 and reducing the risks of film bulging and detachment of the first conductor portion 31.

It should be noted that, according to different actual needs, some of the second type of openings 322 may also be disposed in the spacer region J, or no second type of openings 322 may be disposed in the spacer region J, which is not limited by the embodiments of the present application. Optionally, there is both the first type of openings 321 and the second type of openings 322 in the spacer region J, and the plurality of the second type of openings 322 are located between the first type of adjacent openings 321.

In some embodiments, with reference to Figs. 1, 2, 5, 6b, and 7, the display panel 100 further includes a shift register unit V located between the adjacent pixel circuits P. An orthographic projection of the shift register unit V on the substrate 10 overlaps at least partially with the orthographic projections of the first type of openings 321 on the substrate 10; additionally or alternatively, an orthographic projection of the shift register unit V on the substrate 10 overlaps at least partially with the orthographic projections of the second type of openings 322 on the substrate 10.

The shift register unit V is a type of sequential logic circuit that can store and transmit specific signals. The shift register unit V includes a plurality of cascaded shift register circuits, and the connection between these shift register circuits allows an output terminal of one shift register circuit to be electrically connected to a corresponding signal line and to provide input signals for the next-level shift register circuit.

The display panel 100 may include a display region and a border region located on the periphery of the display region, the display region is a region in the display panel 100 for achieving light emitting display, the light emitting elements F and the corresponding pixel circuits P are all displayed in the display region, and the border region located on the periphery of the display region can be used for configuring some wires and circuit structures. On this basis, the shift register unit V is located between the adjacent pixel circuits P, that is, the shift register unit V is also disposed in the display region, which can save the space required for disposing the shift register unit V in the border region and achieve a narrow border effect of the display panel 100, namely, achieve high screen-to-body ratio display.

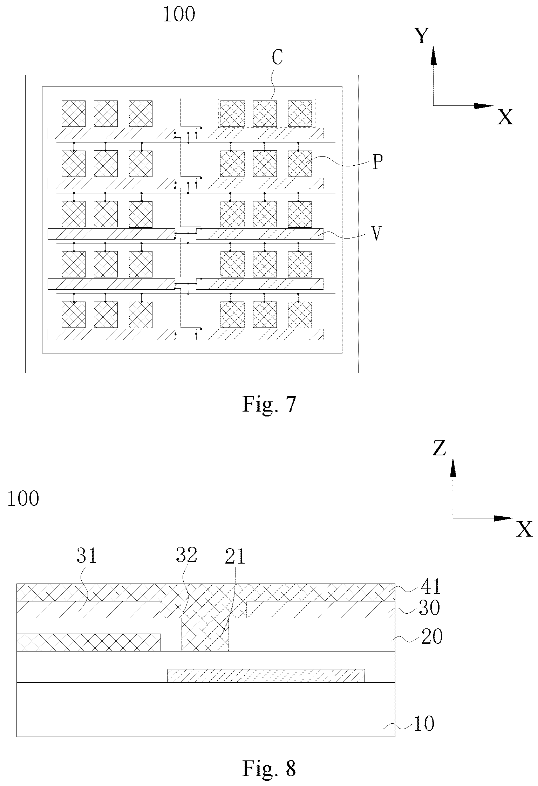

The specific positions of the plurality of shift register circuits in the shift register unit V relative to the pixel circuits P are not limited by the embodiments of the present application. Taking for example that the first direction X is a row direction and that the second direction Y is a column direction, a plurality of pixel circuits P arranged side by side in the first direction X jointly constitute a circuit row, and a plurality of pixel circuits P arranged side by side in the second direction Y jointly constitute a circuit column. In this case, as shown in Fig. 7, the single shift register circuit may be disposed between the adjacent circuit rows or between the adjacent circuit columns, as long as the adjacent shift register circuits are spaced apart in the second direction Y.

In addition, the type of signals output by the shift register unit V is not limited by the embodiments of the present application. For example, the display panel 100 includes scan lines, and the shift register unit V may be electrically connected to the scan line to provide scan signals to the scan line. Alternatively, the display panel 100 includes light emitting control lines, and the shift register unit V may be electrically connected to the light emitting control line to provide light emitting control signals em to the light emitting control line.

Further, in the embodiments of the present application, since the shift register unit V is located between the adjacent pixel circuits P, the orthographic projection of the shift register unit V on the substrate 10 may overlap with the first opening 32 on the substrate 10. Further, according to different actual needs, the shift register unit V may selectively overlap with at least one of the first type of openings 321 and the second type of openings 322, so as to reduce the risk of bulging or film detachment of the display panel 100 in the region where the shift register unit V is located, and to improve the use reliability of the display panel 100.

In some embodiments, with reference to Fig. 8, the first organic layer 20 includes an exhaust hole 21, and orthographic projections of the first opening 32 and the exhaust hole 21 on the substrate 10 overlap at least partially.

The exhaust hole 21 is a hole-shaped structure formed by inward depression of the surface of the first organic layer 20 away from the substrate 10 to achieve an exhaust function. The exhaust hole 21 may completely penetrate the first organic layer 20 in the thickness direction Z, or the exhaust hole 21 may penetrate some structures of the first organic layer 20 in the thickness direction Z. The exhaust hole 21 may have various sizes and shapes, for example, the orthographic projection of the exhaust hole 21 on the substrate 10 may be circular, square, or other regular and irregular shapes.

The orthographic projections of the first opening 32 and the exhaust hole 21 on the substrate 10 overlap at least partially, that is, the first opening 32 corresponds to the exhaust hole 21. The orthographic projection of the first opening 32 on the substrate 10 may completely cover the orthographic projection of the exhaust hole 21 on the substrate 10, or the orthographic projection of the first opening 32 on the substrate 10 may cover the orthographic projections of only some structures in the exhaust hole 21 on the substrate 10.

In the embodiments of the present application, the exhaust hole 21 is added in the display panel 100, and the position of the exhaust hole 21 is set correspondingly to the position of the first opening 32, so that water vapor and the like remaining in the first organic layer 20 can move to the first opening 32 through the exhaust hole 21 and be released through the first opening 32. In this case, the joint cooperation of the first opening 32 and the exhaust hole 21 is conducive to further reducing the risks of film bulging and detachment of the first conductor portion 31 caused by blocked water vapor and improving the production yield and use reliability of the display panel 100.

In some embodiments, as shown in Fig. 8, the orthographic projection of the exhaust hole 21 on the substrate 10 is located within the orthographic projection of the first opening 32 on the substrate 10, and the orthographic projection area of the exhaust hole 21 on the substrate 10 is less than that of the first opening 32 on the substrate 10.

It can be seen from the figure that the orthographic projection area of the exhaust hole 21 is less than that of the first opening 32, and the exhaust hole 21 completely corresponds to the first opening 32, so the first conductor portion 31 can be completely disposed on the surface of the first organic layer 20 away from the substrate 10, that is, the first conductor portion 31 is not located inside the exhaust hole 21, and the first organic layer 20 can provide flat support for the first conductor portion 31.

Further, in the production process of the display panel 100, such design can allow the exhaust hole 21 to be formed after the first opening 32. Specifically, a continuous organic material layer that is of a complete surface structure can be first formed, then the first metal layer 30 is formed on the organic material layer, and the partial structure of the organic material layer at the first opening 32 can be etched and removed by means of the shielding effect of the first conductor portion 31 in the first metal layer 30, to form the first organic layer 20 and the exhaust hole 21 corresponding to the first opening 32.

In this case, the exhaust hole 21 located inside the first organic layer 20 is formed without the need for a mask plate, thereby reducing production difficulty and production cost. Meanwhile, the organic material layer with a complete surface structure can provide a flat and complete surface for the production of the first metal layer 30, thereby reducing the production difficulty of the first metal layer 30 and improving the production reliability of the first metal layer 30.

In summary, in the embodiments of the present application, the exhaust hole 21 is completely located within the first opening 32, so that the first conductor portion 31 is completely located on the surface of the side of the first organic layer 20 away from the substrate 10, which can provide flat support for the first conductor portion 31. And when gas is released through the exhaust hole 21, the first conductor portion 31 is not in the gas release path, which can reduce the risk of detachment or bulging of the first conductor portion 31 relative to the first organic layer 20. Further, the production difficulty and the production cost can be reduced, and the production reliability of the first metal layer 30 can be improved.

In some embodiments, as shown in Fig. 8, the display panel 100 further includes a first insulating layer 41 disposed on the side of the first metal layer 30 away from the substrate 10, and some structures in the first insulating layer 41 are located in the first opening 32 and the exhaust hole 21.

The first insulating layer 41 is a film layer structure located on the side of the first metal layer 30 away from the substrate 10 and including an insulating material. The first insulating layer 41 may have various material compositions; for example, the first insulating layer 41 may include an organic insulating material or an inorganic insulating material. The first insulating layer 41 may be directly in contact with or be spaced apart from the first metal layer 30, that is, other film layer structures may be or may not be sandwiched between the first metal layer 30 and the first insulating layer 41, which is not limited by the embodiments of the present application.

In the embodiments of the present application, the partial structure in the first insulating layer 41 is located in the first opening 32 and the exhaust hole 21, which enables the first insulating layer 41 to provide a relatively flat surface while meeting the insulation requirements of the display panel 100, thereby reducing the adverse effects of the exhaust hole 21 and the first opening 32 on the production of other film layers located on the side of the first insulating layer 41 away from the substrate 10, and improving the production yield and reliability of the display panel 100.

In some embodiments, the first insulating layer 41 is attached to the side wall of the first conductor portion 31 facing the first opening 32.

In the embodiments of the present application, there is no other film layer structures between the first insulating layer 41 and the first metal layer 30, and the first insulating layer 41 can insulate the first conductor portion 31, thereby reducing the risk of contact short-circuits between the first conductor portion 31 and other conductor or semiconductor structures located on the side of the first insulating layer 41 away from the substrate 10, and improving the reliability of signal transmission by the first conductor portion 31.

Further, the first insulating layer 41 is attached to the side wall of the first conductor portion 31 facing the first opening 32. Thus, in the production process of other film layers on the side of the first insulating layer 41 away from the substrate 10, the first insulating layer 41 can cover and protect the first conductor layer, thereby reducing the risk of side etching of the first conductor portion 31 and the risk of oxidation reaction on the side wall of the first conductor portion 31, and improving the structural reliability of the first conductor portion 31.

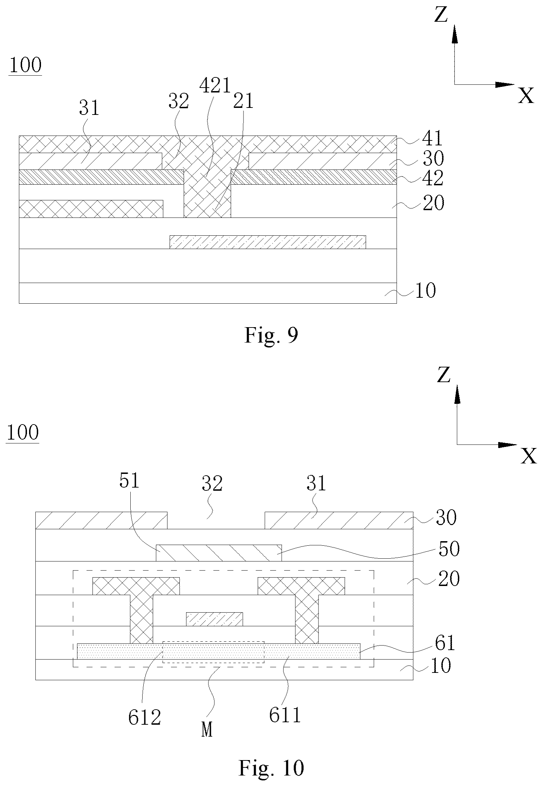

In some embodiments, with reference to Fig. 9, the display panel 100 further includes a second insulating layer 42 disposed between the first metal layer 30 and the first organic layer 20, the second insulating layer 42 includes a second opening 421, and orthographic projections of the second opening 421 and the exhaust hole 21 on the substrate 10 overlap.

The second insulating layer 42 is a film layer structure located between the first organic layer 20 and the first metal layer 30 and including an insulating material. The second insulating layer 42 may have various material compositions; for example, the second insulating layer 42 may include an organic insulating material or an inorganic insulating material. The second insulating layer 42 may be directly in contact with or be spaced apart from the first metal layer 30, that is, other film layer structures may be or may not be sandwiched between the second metal layer 50 and the first insulating layer 41, and the relationship between the second insulating layer 42 and the first organic layer 20 is the same, which are not limited by the embodiments of the present application.

The second insulating layer 42 includes the second opening 421, and the orthographic projections of the second opening 421 and the exhaust hole 21 on the substrate 10 overlap at least partially, that is, the second opening 421 corresponds to the exhaust hole 21. Further optionally, the orthographic projections of the second opening 421 and the first opening 32 on the substrate 10 overlap at least partially. The orthographic projection of the second opening 421 on the substrate 10 may completely cover the orthographic projection of the exhaust hole 21 on the substrate 10, or the orthographic projection of the second opening 421 on the substrate 10 may cover the orthographic projection of only the partial structure in the exhaust hole 21 on the substrate 10.

In the embodiments of the present application, since there is the second insulating layer 42 between the first organic layer 20 and the first metal layer 30, in order to reduce the impact of the second insulating layer 42 on the release of water vapor and other gases in the first organic layer 20, the second opening 421 is added in the second insulating layer 42, and the position of the second opening 421 is set correspondingly to the position of the exhaust hole 21, so that the water vapor and the like remaining in the first organic layer 20 can move to the first opening 32 through the exhaust hole 21 and the second opening 421 sequentially and be released through the first opening 32. In this case, the cooperation of the first opening 32, the second opening 421, and the exhaust hole 21 is conducive to further reducing the risks of film bulging and detachment of the first conductor portion 31 caused by blocked water vapor and improving the production yield and use reliability of the display panel 100.

In some embodiments, the second insulating layer 42 includes an inorganic material.

The inorganic material has relatively stable chemical inertness and a certain effect of isolating water vapor. On this basis, in order to meet the requirements of water vapor release, the second opening 421 is provided in the second insulating layer 42 in the embodiments of the present application, and water vapor can move to the first opening 32 through the exhaust hole 21 and the second opening 421 sequentially and be released through the first opening 32, thereby reducing problems such as bulging caused by water vapor aggregation on the side of the second insulating layer 42 facing the substrate 10, and improving the use reliability of the display panel 100.

In some embodiments, with reference to Fig. 10, the display panel 100 further includes a second metal layer 50 disposed on one side of the substrate 10, the second metal layer 50 includes a second conductor portion 51, and an orthographic projection of the second conductor portion 51 on the substrate 10 overlaps with the orthographic projection of at least a portion of the first opening 32 on the substrate 10.

The second metal layer 50 is of a film layer structure located on the same side of the substrate 10 as the first metal layer 30 and including a metal conductor material, and the second metal layer 50 may be located on the side of the first metal layer 30 facing the substrate 10, or the second metal layer 50 may be located on the side of the first metal layer 30 away from the substrate 10. Further optionally, the display panel 100 includes a first active layer 61, and both the first metal layer 30 and the second metal layer 50 are located on the side of the first active layer 61 away from the substrate 10.

The second metal layer 50 includes the second conductor portion 51. According to different actual needs, the second conductor portion 51 may be used for transmitting the same type of signals as the first conductor portion 31, or transmitting a different type of signals. Further, the second conductor portion 51 may be insulated from the first conductor portion 31, or the second conductor portion 51 may be electrically connected to the first conductor portion 31 via a through hole or the like.

The specific shape and size of the second conductor portion 51 are not limited by the embodiments of the present application. For example, the orthographic projection of the second conductor portion 51 on the substrate 10 may be a planar structure, or the second conductor portion 51 may include a plurality of spaced sub portion structures, and the orthographic projection of the single sub portion structure on the substrate 10 may be a strip or block structure.

The orthographic projection of the second conductor portion 51 on the substrate 10 overlaps with the orthographic projections of at least some of the first openings 32 on the substrate 10, that is, there is an overlapping region between the orthographic projection of the second conductor portion 51 on the substrate 10 and the orthographic projections of at least some of the first opening 32 on the substrate 10. The orthographic projection of the second conductor portion 51 on the substrate 10 may overlap with the orthographic projections of all the first openings 32 on the substrate 10, or the orthographic projection of the second conductor portion 51 on the substrate 10 may overlap with the orthographic projections of only some of the first openings 32 on the substrate 10, while the orthographic projections of the rest of the first openings 32 on the substrate 10 is located outside the orthographic projection of the second conductor portion 51 on the substrate 10.

Further, the first opening 32 and the second conductor portion 51 that overlap with each other may have various positional relationships. For example, the orthographic projection of the second conductor portion 51 on the substrate 10 can completely cover the orthographic projection of the first opening 32 on the substrate 10, or overlap with the orthographic projections of some structures in the first opening 32 on the substrate 10, while the orthographic projections of other structures in the first opening 32 on the substrate 10 are located outside the orthographic projection of the second conductor portion 51 on the substrate 10. Optionally, the orthographic projection of the second conductor portion 51 on the substrate 10 completely covers the orthographic projection of at least a portion of the first opening 32 on the substrate 10.

In the embodiments of the present application, the second conductor portion 51 is not only used for transmitting signals, but its partial structure in the region where the first opening 32 is located can also cover and protect other film layer structures located on the side of the second metal layer 50 facing the substrate 10, such as protect at least some structures in the transistor M, thereby improving the production yield of the display panel 100.

In some embodiments, as shown in Fig. 10, the display panel 100 further includes a first active layer 61 disposed on the side of the second metal layer 50 facing the substrate 10, the first active layer 61 includes a first active structure 611, the first active structure 611 includes a first exposed portion 612, an orthographic projection of the first exposed portion 612 on the substrate 10 is located within the first opening 32, and the orthographic projection of the second conductor portion 51 on the substrate 10 overlaps at least partially with the orthographic projection of the first exposed portion 612 on the substrate 10.

The first active layer 61 is a semiconductor film layer located on the side of the first metal layer 30 and the second metal layer 50 facing the substrate 10. According to different actual needs, the display panel 100 may include only one semiconductor film layer as the first active layer 61, or may include two semiconductor film layers simultaneously. Specifically, when the display panel 100 includes only one semiconductor film layer as the first active layer 61, LTPS technology may be used for the pixel circuits P in the display panel 100. The LTPS technology includes only LTPS (Low Temperature Poly-Silicon)-TFT. In this case, the material of the first active layer 61 includes low temperature poly-silicon. When the display panel 100 includes two semiconductor film layers simultaneously, LTPO technology may be used for the pixel circuits in the display panel 100. The LTPO technology includes both LTPS-TFT and IGZO (Indium Gallium Zinc Oxide)-TFT. In this case, the first active layer 61 may include low temperature poly-silicon or metal oxide.

The first active structure 611 is a semiconductor structure located in the first active layer 61, and the first active structure 611 includes the first exposed portion 612 corresponding to the first opening 32 in position. Based on the aforementioned content, the plurality of first openings 32 include a first type of openings 321 and a second type of openings 322 which are different in size, the orthographic projection of the first type of opening 321 on the substrate 10 may be located outside the orthographic projection of the first active structure 611 on the substrate 10, while there is an overlapping region between the orthographic projection of the second type of opening 322 on the substrate 10 and the orthographic projection of the first active structure 611 on the substrate 10, and a partial structure of the first active structure 611 corresponding to the overlapping region is the first exposed portion 612.

Further, in the embodiments of the present application, the second metal layer 50 is located on the side of the first active layer 61 away from the substrate 10, and the orthographic projection of the second conductor portion 51 on the substrate 10 can overlap with the orthographic projection of the first exposed portion 612 on the substrate 10. In this case, the second conductor portion 51 can protect the first exposed portion 612, thereby reducing the adverse effects of laser bonding and other processes on the first active structure 611 and improving the reliability of the first active structure 611 and the yield of the display panel 100. Meanwhile, the layout of the first active structure 611 may not be limited by the position of the first opening 32, thereby reducing the layout difficulty of the first active structure 611 and improving the display effect and display precision.

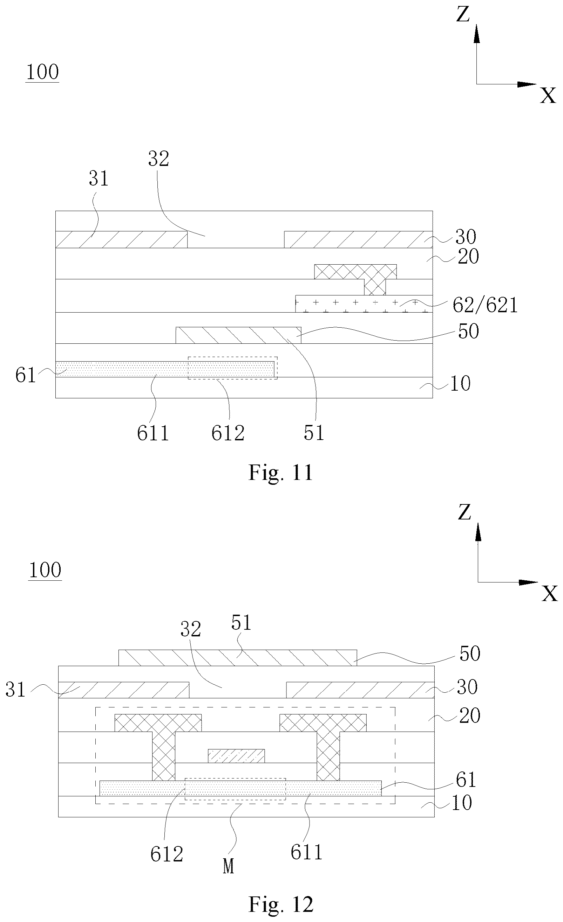

In some embodiments, with reference to Fig. 11, the second metal layer 50 is located on the side of the first metal layer 30 facing the substrate 10, the display panel 100 further includes a second active layer 62 disposed between the second metal layer 50 and the first metal layer 30, the second active layer 62 includes a second active structure 621, and an orthographic projection of the second active structure 621 on the substrate 10 is located outside the orthographic projection of the first exposed portion 612 on the substrate 10.

In the embodiments of the present application, the display panel 100 includes two semiconductor film layers, namely, the first active layer 61 and the second active layer 62. That is, LTPO technology is used for the pixel circuits P, where the material of the first active layer 61 may include low temperature poly-silicon, and the material of the second active layer 62 includes a metal oxide.

The first active layer 61, the first metal layer 30, the second active layer 62, and the second metal layer 50 are sequentially stacked in a direction gradually away from the substrate 10. Based on the aforementioned content, the first active structure 611 in the first active layer 61 includes the first exposed portion 612 corresponding to the first opening 32, and the second conductor portion 51 in the second metal layer 50 can be set to correspond to the first exposed portion 612 to protect the first exposed portion 612, thereby reducing the risk of damage to the first exposed portion 612 due to laser bonding and other processes and improving reliability.

Further, regarding the second active layer 62, because the second active layer 62 is located on the side of the second metal layer 50 away from the substrate 10, the second metal layer 50 cannot protect the second active layer 62 in the subsequent process. On this basis, in order to reduce risks in the second active layer 62, the orthographic projection of the second active structure 621 in the second active layer 62 on the substrate 10 is located outside the orthographic projection of the first opening 32 on the substrate 10 in the embodiments of the present application, and further optionally, the orthographic projection of the second active structure 621 on the substrate 10 can be completely located within the orthographic projection of the first conductor portion 31 on the substrate 10, so that the first conductor portion 31 can protect the second active structure 621 to reduce the risk of damage to the second active structure 621 due to laser bonding and other processes and improve reliability.

In summary, in the embodiments of the present application, because the first active layer 61 is located on the side of the first metal layer 30 and the second metal layer 50 facing the substrate 10, some structures in the first active structure 611, such as the first exposed portion 612, can be set to correspond to the first opening 32, and the first exposed portion 612 can be protected by the second conductor portion 51. Because the second active layer 62 is located between the first metal layer 30 and the second metal layer 50, in order to reduce the impact of subsequent processes on the second active layer 62, the orthographic projection of the second active structure 621 on the substrate 10 is located outside the orthographic projection of the first exposed portion 612 on the substrate 10, to protect the second active structure 621 by means of the first conductor portion 31. Such design can further improve the production yield and use reliability of the display panel 100.

In some embodiments, with reference to Fig. 12, the second metal layer 50 is disposed on the side of the first metal layer 30 away from the substrate 10.

The first metal layer 30 is provided with the first opening 32, and the presence of the first opening 32 is prone to adverse effects on underlying film layer structures in subsequent production processes. On this basis, the second metal layer 50 is located on the side of the first metal layer 30 away from the substrate 10 in the embodiments of the present application, that is, the first metal layer 30 is not the farthest metal film layer from the substrate 10 in the display panel 100. And the orthographic projection of the second conductor portion 51 on the substrate 10 overlaps with the orthographic projection of at least a portion of the first opening 32 on the substrate 10, so that the second conductor portion 51 can protect the exposed portions of the other film layers on the side of the first metal layer 30 facing the substrate 10 relative to the first opening 32, thereby further improving the production yield of the display panel 100.

The specific positional relationship between the first metal layer 30 and the second metal layer 50, as well as the specific types of signals transmitted by the first conductor portion 31 and the second conductor portion 51, are not limited by the embodiments of the present application. Optionally, the second conductor portion 51 includes a first pad and a second pad insulated from each other, and the first pad and the second pad are used for fixing the two electrodes of the light emitting element, respectively. The first conductor portion 31 may be used for transmitting a power voltage signal. On this basis, if the power voltage signal is a PVDD signal, both the first pad and the second pad are insulated from the first conductor portion 31. If the power voltage signal is a PVEE signal, one of the first pad and the second pad may be electrically connected to the first conductor portion 31, while the other is insulated from the first conductor portion 31.

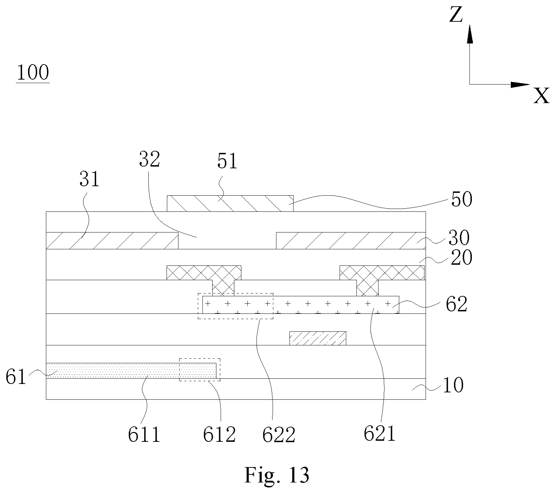

In some embodiments, with reference to Fig. 13, the display panel 100 further includes a second active layer 62 disposed between the first metal layer 30 and the first active layer 61, the second active layer 62 includes a second active structure 621, the second active structure 621 includes a second exposed portion 622, an orthographic projection of the second exposed portion 622 on the substrate 10 is located within the first opening 32, and the orthographic projection of the second conductor portion 51 on the substrate 10 overlaps at least partially with the orthographic projection of the second exposed portion 622 on the substrate 10.

The first active layer 61, the second active layer 62, the first metal layer 30, and the second metal layer 50 are sequentially stacked in the direction gradually away from the substrate 10. The second active structure 621 is a semiconductor structure located in the second active layer 62. In some cases, for different actual layout requirements, the second active structure 621 may include the second exposed portion 622 corresponding to the first opening 32. Based on the aforementioned content, the plurality of first openings 32 include a first type of openings 321 and a second type of openings 322 with different sizes. Optionally, the orthographic projection of the first type of opening 321 on the substrate 10 may be located outside the orthographic projection of the second active structure 621 on the substrate 10, while there is an overlapping region between the orthographic projection of the second type of opening 322 on the substrate 10 and the orthographic projection of the second active structure 621 on the substrate 10, and a partial structure of the second active structure 621 corresponding to the overlapping region is the second exposed portion 622.

Further, in the embodiments of the present application, the second metal layer 50 is located on the side of the second active layer 62 away from the substrate 10, and the orthographic projection of the second conductor portion 51 on the substrate 10 can overlap with the orthographic projection of the second exposed portion 622 on the substrate 10. In this case, the second conductor portion 51 can protect the second exposed portion 622, thereby reducing the adverse effects of laser bonding and other processes on the second active structure 621 and improving the reliability of the second active structure 621 and the yield of the display panel 100. Meanwhile, the layout of the second active structure 621 may not be limited by the position of the first opening 32, thereby reducing the layout difficulty of the second active structure 621 and improving the display effect and display precision.

In some embodiments, as shown in Fig. 12 and Fig. 13, the orthographic projections of the first opening 32 overlapping at least partially with the first active structure 611 among the plurality of first openings 32 and the second conductor portion 51 on the substrate 10 overlap at least partially.

The first opening 32 overlapping at least partially with the first active structure 611 is the first opening 32 overlapping with the orthographic projection of the first exposed portion 612 on the substrate 10. If there is no other shielding structure in the corresponding region of the first opening 32, laser is likely to pass through the first opening 32 and irradiate the first exposed portion 612 in the subsequent laser bonding process, which may pose a risk of damage to the first active structure 611.

In view of this, the orthographic projections of the second conductor portion 51 and the first opening 32 corresponding to the first exposed portion 612 on the substrate 10 overlap in the embodiments of the present application, so that the second conductor portion 51 can provide a shielding effect on the first exposed portion 612, thereby reducing damage of subsequent laser bonding and other processes to the first active structure 611 and improving the use reliability of the display panel 100.

In some optional embodiments, the display panel 100 further includes a second active layer 62 disposed between the first metal layer 30 and the first active layer 61, the second active layer 62 includes a second active structure 621, and the orthographic projections of the first opening 32 overlapping at least partially with the second active structure 621 among the plurality of first openings 32 and the first conductor portion 31 on the substrate 10 overlap at least partially.

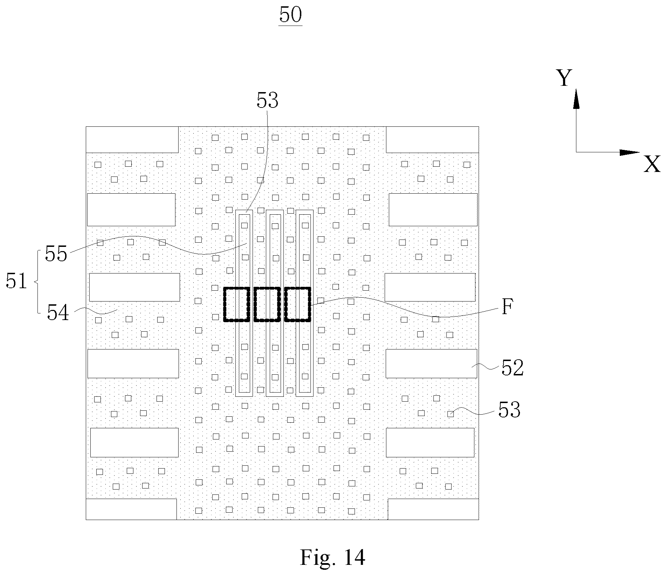

In some embodiments, with reference to Fig. 12 and Fig. 14, the display panel 100 includes a second metal layer 50 on the side away from the substrate 10, the second metal layer 50 includes a second conductor portion 51, the second conductor portion 51 includes a third type of opening 52 and a fourth type of opening 53, and the size of the third type of opening 52 is greater than that of the fourth type of opening 53.

Similar to the first metal layer 30, a plurality of openings may be provided in the second metal layer 50, and the plurality of openings includes a third type of openings 52 and a fourth type of openings 53 with different sizes. The term "size" mentioned here refers to orthographic projection area on the substrate 10, that is, the orthographic projection area of the third type of openings 52 on the substrate 10 is greater than that of the fourth type of openings 53 on the substrate 10.

Further, the third type of openings 52 refer to openings with corresponding orthographic projection area greater than a second preset value, while the fourth type of openings 53 refer to openings with corresponding orthographic projection area less than the second preset value. The specific magnitude of the second preset value is not limited by the embodiments of the present application. Optionally, the first preset value and the second preset value are the same value. The quantity of the third type of openings 52 may be plural, and the shape and size of the third type of different openings 52 on the substrate 10 may be the same or different. Similarly, the quantity of the fourth type of openings 53 may be plural, and the shape and size of the fourth type of different openings 53 on the substrate 10 may be the same or different.

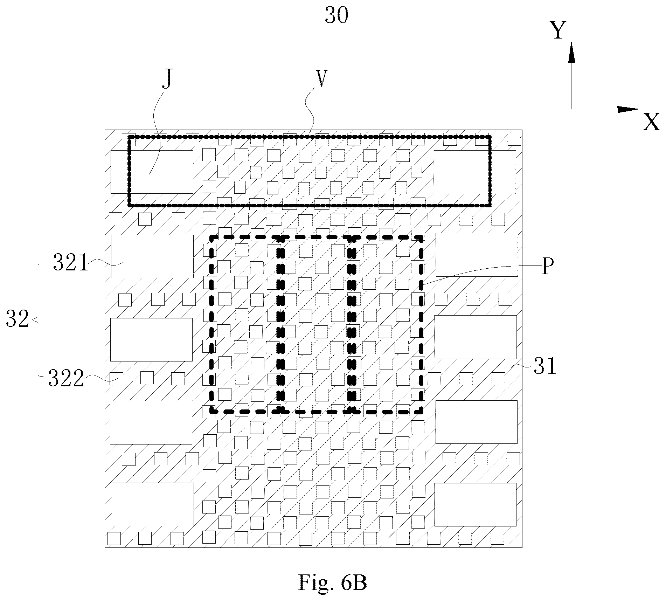

With reference to Fig. 6, the positional relationships of the third type of openings 52 and the fourth type of openings 53 relative to the first type of openings 321 and the second type of openings 322 are not limited by the embodiments of the present application, and the orthographic projections of the third type of openings 52 on the substrate 10 may be located outside the orthographic projections of both the first type of openings 321 and the second type of openings 322 on the substrate 10, or the orthographic projections of the third type of openings 52 on the substrate 10 may overlap with the orthographic projections of one of the first type of openings 321 and the second type of openings 322 on the substrate 10. The fourth type of openings 53 are the same, and will not be repeated by the embodiments of the present application.

In the embodiments of the present application, the second metal layer 50, similar to the first metal layer 30, also includes a plurality of openings with different sizes. On this basis, the third type of openings 52 and the fourth type of openings 53 are conducive to further improving the gas release effect of the display panel 100, reducing the risks of water vapor aggregation on the side of the second metal layer 50 facing the substrate 10 and bulging, and improving the yield and use reliability of the display panel 100.

In some embodiments, as shown in Fig. 4 and Fig. 12, the pixel circuit P includes a low power terminal and a high power terminal, the low power terminal provides low power voltage, the high power terminal provides high power voltage, the first conductor portion 31 is used for transmitting the low power voltage or the high power voltage, and the second conductor portion 51 is used for transmitting the low power voltage or the high power voltage.

For example, the light emitting element in the display panel 100 is a microled and includes a first electrode and a second electrode. Next, the embodiments of the present application will introduce the pixel circuit P. The pixel circuit P includes a pulse width modulation circuit P1 and a pulse amplitude modulation circuit P2, the pulse width modulation circuit P1 is configured to control, based on pulse width modulation data voltage, the pulse width of driving current provided to the light emitting element, and the pulse amplitude modulation circuit P2 is configured to control, based on pulse amplitude modulation data voltage, the amplitude of the driving current provided to the light emitting element. The pulse width of the driving current can be understood as duration of the driving current, and the amplitude of the driving current can be understood as a current value of the driving current.

Further, as shown in Fig. 4A and Fig.4b, the pixel circuit P may include a pulse width modulation circuit P1 and a pulse amplitude modulation circuit P2, and the pixel circuit P generates driving current under the control of the pulse amplitude modulation circuit P2 and the pulse width modulation circuit P1. The pulse amplitude modulation circuit P2 can be used for controlling the amplitude of the driving current, and the pulse width modulation circuit P1 can be used for adjusting the pulse width of voltage applied to the second electrode of the light emitting element F. The pulse width modulation circuit P1 adjusts the pulse width of voltage applied to the second electrode of the light emitting element F, that is, adjusts the actual emitting period of the driving current applied to the light emitting element F. Meanwhile, the pulse width modulation circuit P1 can maintain the driving current applied to the light emitting element F at a constant level to adjust the gray scale or brightness displayed by the light emitting element F, rather than adjusting the gray scale or brightness displayed by the light emitting element F by adjusting the magnitude of the driving current applied to the light emitting element F. Therefore, the pulse amplitude modulation circuit P2 can provide the driving current for the light emitting element F to drive the light emitting element F with optimal luminous efficiency, and the pulse width modulation circuit P1 adjusts the luminous duty cycle of the light emitting element F (namely, the emitting period of the light emitting element F) to adjust the gray scale or brightness displayed by the light emitting element F. An output terminal of the pulse width modulation circuit P1 may be directly connected to a control terminal of a driving transistor in the pulse amplitude modulation circuit P2, that is, an electrical signal output from the output terminal of the pulse width modulation circuit P1 is directly written to the control terminal of the driving transistor to adjust the amplitude of the driving current.

It should be noted that the figure only illustrates one connection method between the pulse width modulation circuit P1 and the pulse amplitude modulation circuit P2. According to different actual needs, the two circuits may also be connected in various other forms, which are not limited by the embodiments of the present application. In some other embodiments, the output terminal of the pulse width modulation circuit P1 may be connected to the pulse amplitude modulation circuit P2 by a first capacitor. Specifically, the pixel circuit P further includes the first capacitor, a first electrode plate of the first capacitor is electrically connected to the output terminal of the pulse width modulation circuit P1, and a second electrode plate of the first capacitor is electrically connected to the pulse amplitude modulation circuit P2. The second electrode plate of the first capacitor is connected to the control terminal of the controlled transistor. The controlled transistor may be the driving transistor that generates the driving current in the pulse amplitude modulation circuit P2, or another transistor connected in series with the driving transistor in the pulse amplitude modulation circuit P2.

Further, the specific circuit compositions in the first driving circuit and the second driving circuit are not limited by the embodiments of the present application. For example, as shown in Fig. 4A, the pulse width modulation circuit P1 includes a first driving transistor M1, a first gate reset transistor M2, a first data write transistor M3, a first compensation transistor M4, a first control transistor M6, a third control transistor M5, and a storage capacitor Cst. The third control transistor M5 is connected between first power voltage PWM-vdd and a first electrode of the first driving transistor M1, and the first control transistor M6 is connected between a second electrode of the second driving transistor M1 and an output terminal of the first driving circuit. The first data write transistor M3 is connected to a first electrode of the second driving transistor M1, the first compensation transistor M4 is connected to the second electrode and control terminal of the second driving transistor M1, and the first gate reset transistor M2 is connected to the control terminal of the second driving transistor M1. A first electrode plate of the storage capacitor Cst is connected to a control terminal of the first driving transistor M1, and a second electrode plate of the storage capacitor Cst is connected to a sweep signal SWEEP. The control terminal of the first gate reset transistor M2 receives a first scan signal PWM-S1, and gates of the first data write transistor M3 and the first compensation transistor M4 receive a second scan signal PWM-S2. Gates of the first control transistor M6 and the third control transistor M5 receive a first light emitting control signal PWM-EM.

The pulse amplitude modulation circuit P2 includes a second driving transistor M7, a second gate reset transistor M8, a second data write transistor M9, a second compensation transistor M10, a second control transistor M11, a fourth control transistor M12, and an electrode reset transistor M13. The second control transistor M11 is connected between second power voltage PAM-vdd and a first electrode of the second driving transistor M7, and the fourth control transistor M12 is connected between a second electrode of the second driving transistor M7 and the light emitting element F. The second driving transistor M7 is configured to generate driving current under the control of its control terminal voltage. The second data write transistor M9 is connected to the first electrode of the second driving transistor M7, the second compensation transistor M10 is connected to the second electrode and control terminal of the second driving transistor M7, the second gate reset transistor M8 is connected to the control terminal of the second driving transistor M7, the electrode reset transistor M13 is connected to the second electrode of the light emitting element F, the fourth control transistor M12 is also connected to the second electrode of the light emitting element F, and the first electrode of the light emitting element F is connected to third power voltage PVEE. A control terminal of the second gate reset transistor M8 receives a third scan signal PAM-S1; control terminals of the second data write transistor M9, the second compensation transistor M10, and the electrode reset transistor M13 receive a fourth scan signal PAM-S2. Gates of the second control transistor M11 and the fourth control transistor M12 receive a second light emitting control signal PAM-EM.

Alternatively, as shown in Fig. 4B, both the pulse amplitude modulation circuit P2 and the pulse width modulation circuit P1 include an initialization unit 111/121, a data write unit 112/122, a threshold compensation unit 113/123, a light emitting control unit 114/124, a storage capacitor C1/C2, and a driving transistor PAM-DR/PWM-DR (where the pulse amplitude modulation circuit P2 includes an initialization unit 111, a data write unit 112, a threshold compensation unit 113, a light emitting control unit 114, a storage capacitor C2, and a driving transistor PAM-DR; the pulse width modulation circuit P1 includes an initialization unit 121,a data write unit 122, a threshold compensation unit 123, a light emitting control unit 124, a storage capacitor C2, and a driving transistor PWM-DR), where the initialization unit 111/121 is electrically connected to an initialization signal VREF and a first node N11/N12, and the initialization unit 111/121 is used for providing an initialization signal VREF to the first node N11/N12 in an initialization phase (the initialization signal provided by an initialization signal terminal of the pulse amplitude modulation circuit P2 and the initialization signal provided by the pulse width modulation circuit P1 may have the same value or different values). The data write unit 112/122 is electrically connected between a data signal PAM-DATA/PWM-DATA and a first electrode of the driving transistor PAM-DR/PWM-DR, and a control terminal of the driving transistor PAM-DR/PWM-DR and a first electrode plate of the storage capacitor C2/C1 are electrically connected to the first node N11/N12; the data write unit 112/122 is used for providing the data signal PAM-DATA/PWM-DATA to the first node N11/N12 through the driving transistor PAM-DR/PWM-DR in a data write phase. The threshold compensation unit 113/123 is electrically connected between a second electrode of the driving transistor PAM-DR/PWM-DR and the first node N11/N12, and the threshold compensation unit 113/123 is used for compensating threshold voltage of the driving transistor PAM-DR/PWM-DR to the first node N11/N12.

In the pulse width modulation circuit P1, a second electrode plate of the storage capacitor C1 is electrically connected to a sweep signal SWEEP, and the light emitting control unit 124 is electrically connected between first power voltage PWM-vdd and the first node N11 in the pulse amplitude modulation circuit P2; the light emitting control unit 124 is used for controlling the driving transistor PWM-DR to generate driving pulses in a light emitting phase.

In the pulse amplitude modulation circuit P2, a second electrode plate of the storage capacitor C2 is electrically connected to a second power signal PAM-vdd, and the light emitting control unit 114 is electrically connected between the second power signal PAM-vdd and the light emitting element F; the light emitting control unit 114 is used for controlling the driving transistor PAM-DR to generate driving current that flows into the light emitting element F in the light emitting phase, to drive the light emitting element F to emit light.

On this basis, regardless of the circuit structure shown in Fig. 4A or the circuit structure shown in Fig. 4B, the low power voltage includes third power voltage PVEE, and the high power voltage includes power voltage PVDD, where the power voltage PVDD includes first power voltage PWM-vdd and second power voltage PAM-vdd. Further, both the first conductor portion 31 and the second conductor portion 51 may be used for transmitting one of the low power voltage and the high power voltage. The first conductor portion 31 and the second conductor portion 51 may be used for transmitting the same power voltage simultaneously, and the first conductor portion 31 and the second conductor portion 51 may be connected to each other via a through hole. Alternatively, the first conductor portion 31 and the second conductor portion 51 may be used for transmitting different signals separately, and the first conductor portion 31 and the second conductor portion 51 are insulated from each other.

In the embodiments of the present application, for the specific circuit form of the pixel circuit P, in order to meet the light emitting display requirements of the display panel 100, both the first conductor portion 31 and the second conductor portion 51 are configured to transmit the low power voltage or the high power voltage, thereby meeting the transmission requirements of power voltage and achieving the light emitting display function of the display panel 100.

In some embodiments, the first conductor portion 31 and the second conductor portion 51 transmit different signals.

In the embodiments of the present application, the first conductor portion 31 and the second conductor portion 51 transmit different signals, that is, one of them is used for transmitting the low power voltage, and the other is used for transmitting the high power voltage. The orthographic projections of the first conductor portion 31 and the second conductor portion 51 on the substrate 10 may have an overlapping region. On this basis, since the low power voltage and the high power voltage are both constant voltage potentials, even if the first conductor portion 31 and the second conductor portion 51 transmit different signals and have an overlapping region, parasitic capacitance is not easily produced, which is conducive to improving the reliability of signal transmission by the first conductor portion 31 and the second conductor portion 51 and improving the display effect of the display panel 100.

In some embodiments, the pixel circuit P includes a pulse amplitude modulation circuit P2 and a pulse width modulation circuit P1, the pulse amplitude modulation circuit P2 is configured to control the amplitude of driving current based on modulation data, and the pulse width modulation circuit P1 is configured to control the pulse width of the driving circuit. The pulse modulation circuit includes a first power terminal, the first power terminal is used for providing first power voltage PWM-vdd, the first conductor portion 31 transmits the first power voltage PWM-vdd, the pulse amplitude modulation circuit P2 includes a second power terminal, the second power terminal is used for providing second power voltage PAM-vdd, and the second conductor portion 51 transmits the second power voltage PAM-vdd.

In the embodiments of the present application, both the first conductor portion 31 and the second conductor portion 51 can be used for transmitting the power voltage PVDD, but the difference is that the first conductor portion 31 is used for transmitting the first power voltage PWM-vdd, and the second conductor portion 51 is used for transmitting the second power voltage PAM-vdd. On this basis, the first conductor portion 31 and the second conductor portion 51 still need to be insulated from each other, and because the two are used for transmitting constant voltage potentials, even if the first metal layer 30 and the second metal layer 50 are two adjacent metal layers and there is an overlapping region between the first conductor portion 31 and the second conductor portion 51, parasitic capacitance is not easily produced, which is conducive to improving the reliability of signal transmission inside the display panel 100, improving the display effect and prolonging the service life.

In some embodiments, with reference to Figs. 12, 14, and 15, in a direction perpendicular to the plane where the display panel 100 is located, the third type of openings 52 do not overlap with the pixel circuit P; additionally or alternatively the fourth type of openings 53 overlap at least partially with the pixel circuit P.

The third type of openings 52 do not overlap with the pixel circuit P, that is, the orthographic projections of the third type of openings 52 on the substrate 10 may be located outside the orthographic projection of each transistor M in the pixel circuit P on the substrate 10. The fourth type of openings 53 overlap at least partially with the pixel circuit P, that is, the orthographic projections of the fourth type of openings 53 on the substrate 10 overlap with the orthographic projections of the transistors M in the pixel circuit P on the substrate 10.

In the embodiments of the present application, the third type of openings 52 has an opening structure with a large size. The third type of openings 52 does not overlap with the pixel circuit P, which can achieve an exhaust function outside the region where the pixel circuit P is located, improve the gas release effect, and reduce the risk of performance degradation caused by large-area exposure of the pixel circuit P to the third type of openings 52. For the fourth type of openings 53, at least some of the fourth type of openings 53 overlap with the pixel circuit P, so that the exhaust requirements at the region where the pixel circuit P is located can be met by means of the fourth type of openings 53. The fourth type of openings 53 have an opening structure with a small size, so the exposed area of the pixel circuit P at the fourth type of openings 53 is relatively small, which can reduce the degree of performance degradation of the pixel circuit P due to light irradiation and laser bonding and is conducive to improving the production yield and use effect of the display panel 100.

In some optional embodiments, in the direction perpendicular to the plane where the display panel 100 is located, the third type of openings 52 do not overlap with the pixel circuit P, and the fourth type of openings 53 overlap at least partially with the pixel circuit P.

In some embodiments, the orthographic projections of the third type of openings 52 on the substrate 10 are located between the orthographic projections of the adjacent pixel circuits P on the substrate 10.

In the embodiments of the present application, considering that at least some adjacent pixel circuits P may have a large spacing size, the third type of openings 52 are correspondingly disposed between adjacent pixel openings. Such design can improve the gas release capability of the second conductor portion 51 and reduce the risk of detachment of the second conductor portion 51 by means of the third type of openings 52. On the other hand, such design can also meet the avoidance requirements of the third type of openings 52 relative to the pixel circuits P, thereby reducing the risk of performance and yield degradation caused by the large-area exposure of the pixel circuits P to the third type of openings 52.

It should be noted that only one third type of opening 52 or a plurality of the third type of openings 52 may be disposed between the same two adjacent pixel circuits P, which is not limited by the embodiments of the present application. Optionally, a plurality of the third type of openings 52 may be disposed between two adjacent pixel circuits P in the first direction X, and the plurality of the third type of openings 52 may be spaced apart side by side in the second direction Y.

In some embodiments, a plurality of adjacent pixel circuits P jointly form a repeat circuit group C, and a plurality of repeat circuit groups C are repeatedly arranged, where the adjacent repeat circuit groups C are spaced apart to form a spacer region J, and the third type of openings 52 are located in the spacer region J.

In the embodiments of the present application, the spacer region J is such a region that is located between the adjacent repeat circuit groups C and where no pixel circuit P is provided. Compared to the distance between the two adjacent pixel circuits P in the single repeat circuit group C, the distance between the two adjacent pixel circuits P in the adjacent repeat circuit groups C is often longer. On this basis, by disposing the third type of openings 52 in the spacer region J, the third type of openings 52 are located between the two adjacent pixel circuits P in the adjacent repeat circuit groups C. In this case, the third type of openings 52 avoid the pixel circuits P, and the third type of openings 52 has a relatively large size, thereby improving the gas release capability of the second conductor portion 51 and reducing the risks of film bulging and detachment of the second conductor portion 51.

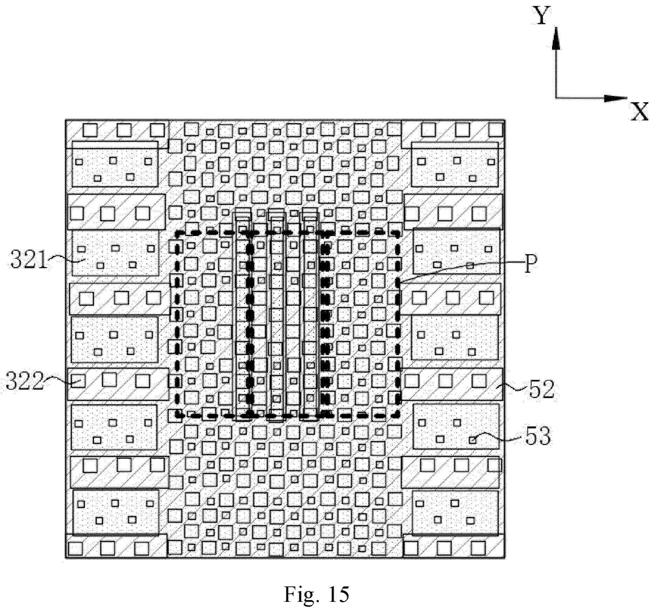

In some embodiments, as shown in Fig. 14 and Fig. 15, the second conductor portion 51 includes a first pad 54 and a second pad 55 that are insulated, and the second pad 55 is connected to the pixel circuit P. The first pad 54 includes the fourth type of opening 53; additionally or alternatively the second pad 55 includes the fourth type of opening 53.

In the embodiments of the present application, the first metal layer 30 is a metal film layer connected to the light emitting element F. Specifically, the light emitting element F may include a first electrode and a second electrode, the first pad 54 may be connected and fixed to the first electrode by laser bonding, and the second pad 55 may be connected and fixed to the second electrode by laser bonding.

The second pad 55 is connected to the pixel circuit P, that is, the second pad 55 is a pad used for achieving the electrical connection between the pixel circuit P and the first electrode. On this basis, the first pad 54 is used for transmitting the third power voltage PVEE.

The size and shape of the first pad 54 and the second pad 55 are not limited by the embodiments of the present application, as long as the first pad 54 and the second pad 55 are insulated from each other. For example, the first pad 54 may have a complete surface structure with a through hole structure in some regions, and the second pad 55 is accommodated in the through hole structure and insulated from the first pad 54.

Further, in the embodiments of the present application, since the fourth type of opening 53 has an opening structure with a small size, the fourth type of opening 53 may be disposed on either the first pad 54 or the second pad 55. That is, the fourth type of opening 53 may be selectively disposed on at least one of the first pad 54 and the second pad 55 according to different actual needs, so as to meet the exhaust needs at the second conductor portion 51, with strong practicality and flexibility.

It should be noted that, in some optional embodiments, the fourth type of opening 53 may be provided on the first pad 54, and the fourth type of opening 53 may also be provided on the second pad 55. On this basis, the size and shape parameters of the fourth type of opening 53 located on the first pad 54 may be the same as or different from those of the fourth type of opening 53 located on the second pad 55, which is not limited by the embodiments of the present application.

In some embodiments, the size of the fourth type of opening 53 on the first pad 54 is greater than that of the fourth type of opening 53 on the second pad 55.

The size of the fourth type of opening 53 on the first pad 54 is the area of the orthographic projection of the fourth type of opening 53 located on the first pad 54 on the substrate 10. Similarly, the size of the fourth type of opening 53 on the second pad 55 is the area of the orthographic projection of the fourth type of opening 53 located on the second pad 55 on the substrate 10.

Based on the aforementioned content, the first pad 54 may have a complete surface structure, so the size of the first pad 54 is often greater than that of the second pad 55. On this basis, the embodiments of the present application address the size difference between the first pad 54 and the second pad 55, and configure the size of the fourth type of opening 53 on the first pad 54 to be greater than that of the fourth type of opening 53 on the second pad 55, that is, the fourth type of openings 53 with a large size are provided with on the large-sized pad, and the fourth type of openings 53 with a small size are provided with on the small-sized pad. Such design can meet the requirements of forming the fourth type of openings 53 on the first pad 54 and the second pad 55, so that the first pad 54 and the second pad 55 can still have certain sizes to meet corresponding signal transmission requirements. Accordingly, the exhaust requirements of the second conductor portion 51 are met, and the display reliability of the display panel 100 is improved.

In some embodiments, as shown in Fig. 14, the first pad 54 includes the fourth type of ring-shaped opening 53, and the second pad 55 is located in the fourth type of ring-shaped opening 53. The third type of opening 52 is disposed on the first pad 54 and spaced apart from the fourth type of ring-shaped opening 53.

The first pad 54 and the second pad 55 need to be insulated from each other, that is, spaced apart from each other. On this basis, in the embodiments of the present application, the fourth type of ring-shaped opening 53 is formed in the first pad 54, the second pad 55 is located inside the ring-shaped structure and the ring-shaped structure surrounds the second pad 55, and the first pad 54 is located on the outer side of the ring-shaped structure and surrounds the ring-shaped structure.

In the production process of the second metal layer 50, the fourth type of ring-shaped opening 53 may be formed by etching. In this case, the conductor structure located inside the ring-shaped structure is the second pad 55, and the conductor structure located outside the ring-shaped structure is the first pad 54.

It should be noted that, except for the fourth type of ring-shaped opening 53, the shape of the fourth type of other openings 53 is not limited by the embodiments of the present application. Optionally, the orthographic projections of the fourth type of other openings 53 on the substrate 10 may be circular, square, or other regular or irregular shapes.

Further, in the embodiments of the present application, considering that the first pad 54 may have a large size, the third type of opening 52 may be provided on the first pad 54. On this basis, considering that the second pad 55 is small-sized and connected to the pixel circuit P, the region near the fourth type of ring-shaped opening 53 usually corresponds to the region where the pixel circuit P is located. Further, in order to reduce the adverse effects of the third type of opening 52 on the pixel circuit P, the third type of opening 52 is further spaced apart from the fourth type of ring-shaped opening 53 in the embodiments of the present application, to reduce the degree of overlap between the orthographic projection of the third type of opening 52 on the substrate 10 and the orthographic projection of the pixel circuit P on the substrate 10. Such design can improve the exhaust capacity of the second conductor portion 51, reduce the adverse effects of the third type of opening 52 on the pixel circuit P, and improve the performance reliability of the pixel circuit P and the production yield of the display panel 100.

In some embodiments, as shown in Figs. 6, 12, 14, and 15, the plurality of first openings 32 include a first type of openings 321 and a second type of openings 322, and the size of the first type of openings 321 is greater than that of the second type of openings 322. On the plane perpendicular to the plane where the display panel is located 100, the first type of openings 321 do not overlap with the pixel circuit P, and at least some of the second type of openings 322 overlap with the pixel circuit P. On the plane perpendicular to the plane where the display panel is located 100, at least some of the second type of openings 322 do not overlap with the fourth type of openings 53, additionally or alternatively at least some of the first type of openings 321 do not overlap with the third type of openings 52.

There is the first type of opening 321 and the second type of opening 322 with different sizes in the first conductor portion 31, and there is the third type of opening 52 and the fourth type of opening 53 with different sizes in the second conductor portion 51. Both the first type of opening 321 and the third type of opening 52 do not overlap with the pixel circuit P, while both the second type of opening 322 and the fourth type of opening 53 overlap at least partially with the pixel circuit P.

On this basis, in the embodiments of the present application, the second type of openings 322 do not overlap with the fourth type of openings 53, that is, the second type of openings 322 do not correspond to the fourth type of openings 53, and the orthographic projections of the second type of openings 322 and the fourth type of openings 53 on the substrate 10 are misaligned. On this basis, in the region where at least some of the second type of openings 322 are located, there are no the fourth type of openings 53, but there are corresponding conductor structures in the second conductor portion 51. Similarly, in the region where at least some of the fourth type of openings 53 are located, there are no the second type of openings 322, but there are corresponding conductor structures in the first conductor portion 31.

In this case, the joint design and coordination of the first conductor portion 31 and the second conductor portion 51 can reduce the risk of large-area exposure of other film layer structures on the side of the first metal layer 30 and the second metal layer 50 facing the substrate 10 due to the corresponding arrangement of the second type of openings 322 and the fourth type of openings 53, thereby reducing the adverse effects of laser bonding and other processes on the other film layers on the side of the first metal layer 30 and the second metal layer 50 facing the substrate 10, and improving the yield and use reliability of the display panel 100. The relationship between the first type of openings 321 and the third type of openings 52 is the same, and will not be repeated in the embodiments of the present application.

It should be noted that the positional relationship between the first type of openings 321 and the fourth type of openings 53 is not limited by the embodiments of the present application. For example, the first type of openings 321 and the fourth type of openings 53 may overlap each other or be misaligned with each other. Similarly, the positional relationship between the second type of openings 322 and the third type of openings 52 is not limited by the embodiments of the present application.

In addition, for different regions of the display panel 100, the second type of openings 322 and the fourth type of openings 53 may not overlap in some regions, while the second type of openings 322 and the fourth type of openings 53 may overlap in other regions. Alternatively, at each region of the display panel 100, the second type of openings 322 and the fourth type of openings 53 do not overlap.

In some optional embodiments, in the region where the pixel circuit P is located, the orthographic projections of the fourth type of openings 53 on the substrate 10 do not overlap with the second type of openings 322, and the third type of openings 52 and the first type of openings 321 are both located outside the region where the pixel circuit P is located. This design enables the pixel circuit P to be covered by the conductor structure in at least one of the first conductor portion 31 and the second conductor portion 51 in the area where the pixel circuit P is located, thereby reducing the adverse effects of laser bonding and other processes on the pixel circuit P and improving the reliability of the pixel circuit P.

For the first type of openings 321 and the third type of openings 52, in some optional embodiments, the third type of openings 52 and the first type of openings 321 do not overlap in the region between the corresponding adjacent pixel circuits P. This design enables at least some positions in the corresponding regions of the third type of openings 52 and the first type of openings 321 to be covered by the conductor structures in the first conductor portion 31 and the second conductor portion 51 respectively, thereby reducing the adverse effects of laser bonding and other processes on the other film layer structures on the side of the first metal layer 30 and the second metal layer 50 facing the substrate 10, and improving the yield and use reliability of the display panel 100.

In some embodiments, the orthographic projections of some of the second type of openings 322 on the substrate 10 are located between the orthographic projections of the adjacent pixel circuits P on the substrate 10, and the orthographic projections of the plurality of the second type of openings 322 on the substrate 10 overlap at least partially with the orthographic projection of the same third type of opening 52 on the substrate 10; additionally or alternatively the orthographic projections of some of the fourth type of openings 53 on the substrate 10 are located between the orthographic projections of the adjacent pixel circuits P on the substrate 10, and the orthographic projections of the plurality of the fourth type of openings 53 on the substrate 10 overlap at least partially with the orthographic projection of the same first type of opening 321 on the substrate 10.

Taking the third type of opening 52 as an example, the third type of opening 52 does not correspond to the first type of opening 321, but corresponds to the plurality of the second type of openings 322. Therefore, water vapor and the like can move to the third type of opening 52 through the plurality of the second type of openings 322 sequentially and be released from the third type of opening 52, thereby providing an exhaust path parallel to the thickness direction Z for gas release, reducing the difficulty of gas release, improving the exhaust reliability of the display panel 100, reducing the risk of bulging or falling of some film layers, and improving the yield.

In addition, the third type of opening 52 is a large-sized opening, and the second type of opening 322 is a small-sized opening, so in the region where the third type of opening 52 is located, some conductor structures between the second type of adjacent openings 322 can cover and protect the other film layers on the side of the first metal layer 30 and the second metal layer 50 facing the substrate 10, thereby reducing the adverse effects of laser bonding and other processes on the other film layer structures on the side of the first metal layer 30 and the second metal layer 50 facing the substrate 10, and improving the yield of the display panel 100. The first type of opening 321 is the same, and will not be repeated in the embodiments of the present application.

In summary, in the embodiments of the present application, the third type of opening 52 does not overlap with the first type of opening 321, the third type of opening 52 overlaps with the plurality of the second type of openings 322, and the first type of opening 321 overlaps with the plurality of the fourth type of openings 53, so that at the positions of the third type of opening 52 and the first type of opening 321, there are not only small-sized opening structures to improve the exhaust effect of the display panel 100 but also conductor structures to cover and protect the other film layers on the side of the first metal layer 30 and the second metal layer 50 facing the substrate 10, thereby further improving the yield and use reliability of the display panel 100.

In some embodiments, in the region between the adjacent pixel circuits P, the orthographic projection of the second type of opening 322 on the substrate 10 overlaps at least partially with the orthographic projection of the fourth type of opening 53 on the substrate 10.

Considering that the region between the adjacent pixel circuits P has no pixel circuits P, even if the metal layer has an opening structure in the region, adverse effects on the pixel circuits P are not easily produced. In view of this, in the embodiments of the present application, in the region between the adjacent pixel circuits P, the second type of opening 322 with a small size overlaps at least partially with the fourth type of opening 53, which improves the exhaust effect of the display panel 100 without affecting the performance of the pixel circuits P.

In some embodiments, as shown in Fig. 1, the first conductor portion 31 includes a first sub portion 311 and a second sub portion 312 adjacent to each other in the first direction X on two sides of the first opening 32, the first sub portion 311 and the second sub portion 312 transmit the same signals, and the first direction X is parallel to the plane where the substrate 10 is located.

The first sub portion 311 and the second sub portion 312 are conductor structures of the first conductor portion 31 on different sides of the first opening 32 in the first direction X. The first sub portion 311 and the second sub portion 312 transmit the same signals, that is, transmit the same potential voltage. The specific relationship between the first sub portion 311 and the second sub portion 312 is not limited by the embodiments of the present application. For example, the first sub portion 311 and the second sub portion 312 may be connected into a whole by other conductor structures in the first conductor portion 31, or separately connected to the same conductor structure in other film layers on the side of the first metal layer 30 facing or away from the substrate 10, or electrically connected by other conductor structures in the first metal layer 30, to transmit the same signals.

In the embodiments of the present application, the first sub portion 311 and the second sub portion 312 in the first conductor portion 31 are disposed on two sides of the first opening 32, and the first sub portion 311 and the second sub portion 312 transmit the same signals, so that more conductor structures in the first conductor portion 31 can transmit the same signals, thereby increasing the sizes of the conductor structures used for transmitting the same signals in the first conductor portion 31, reducing the resistance and load of the first conductor portion 31, and improving the reliability of signal transmission.

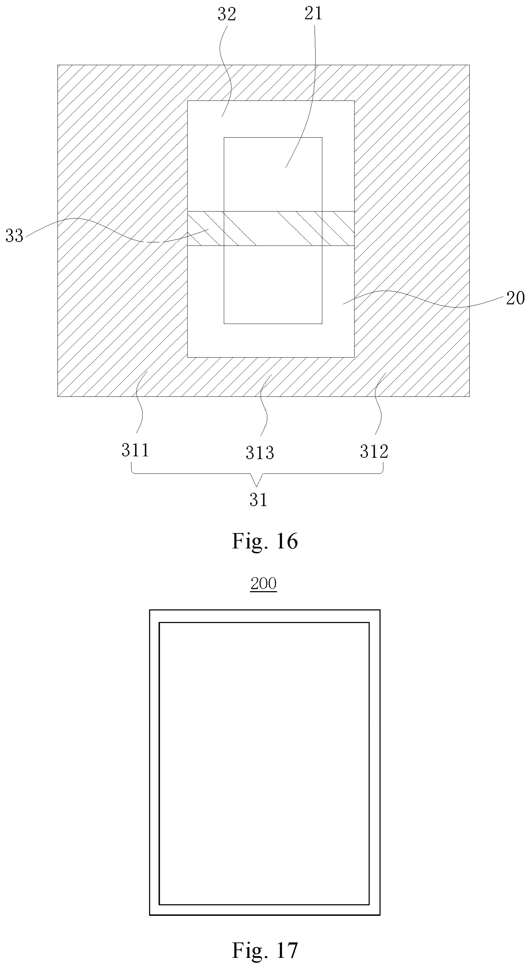

In some embodiments, with reference to Fig. 1 and Fig. 16, the first sub portion 311 and the second sub portion 312 are connected into a whole.

In the embodiments of the present application, the first sub portion 311 and the second sub portion 312 may be connected into a whole by a connecting portion 313, the connecting portion 313 is a conductor structure of the first conductor portion 31 that is disposed on at least one side of the first opening 32 in the second direction Y, and two ends of the connecting portion 313 in the first direction X are connected to the first sub portion 311 and the second sub portion 312 respectively. This design enables the first conductor portion 31 to have a complete surface or block structure with the first opening 32, thereby reducing the difficulty of producing the first conductor portion 31, reducing the resistance and load of the first conductor portion 31, and improving the reliability of signal transmission.

In some embodiments, as shown in Fig. 1 and Fig. 16, the first metal layer 30 further includes a conductive portion 33 extending in the first direction X, an orthographic projection of the conductive portion 33 on the substrate 10 is located within the first opening 32, and the conductive portion 33 connects the first sub portion 311 and the second sub portion 312.

In addition to the first conductor portion 31, the first metal layer 30 further includes the conductive portion 33, and the conductive portion 33 may include the same material as the first conductor portion 31, or the conductive portion 33 may include a different material from the first conductor portion 31. Further optionally, the first conductor portion 31 and the conductive portion 33 may include the same material and be formed together in the same production process.

In the embodiments of the present application, the conductive portion 33 is correspondingly located within the first opening 32, and the two ends of the conductive portion 33 in the first direction X may be connected to the first sub portion 311 and the second sub portion 312 respectively. Based on the aforementioned content, the first sub portion 311 and the second sub portion 312 are connected into a whole. On this basis, the presence of the conductive portion 33 can further help signal transmission between the first sub portion 311 and the second sub portion 312, and can also further reduce the resistance and load of the first conductor portion 31 and improve the reliability of signal transmission.

In some embodiments, the pixel circuit P includes a pulse amplitude modulation circuit P2 and a pulse width modulation circuit P1, the pulse amplitude modulation circuit P2 is configured to control the amplitude of driving current based on applied pulse amplitude modulation data, and the pulse width modulation circuit P1 is configured to control the pulse width of the driving current; the pulse width modulation circuit P1 includes a first power terminal, the first power terminal is used for providing first power voltage, the first conductor portion 31 transmits the first power voltage PWM-vdd, additionally or alternatively the pulse amplitude modulation circuit P2 includes a second power terminal, the second power terminal is used for providing second power voltage PAM-vdd, and the first conductor portion 31 transmits the second power voltage PAM-vdd.

The power voltage PVDD includes the first power voltage PWM-vdd and the second power voltage PAM-vdd. Further, according to different actual needs, the first conductor portion 31 in the first metal layer 30 may be used for transmitting one of the first power voltage PWM-vdd and the second power voltage PAM-vdd. Of course, the first conductor portion 31 may include different conductor structures insulated from each other, and the different conductor structures are used for transmitting the first power voltage PWM-vdd and the second power voltage PAM-vdd respectively.

In the embodiments of the present application, for the specific circuit form of the pixel circuit P, in order to meet the light emitting display requirements of the display panel 100, the first conductor portion 31 is configured to transmit at least one of the first power voltage PWM-vdd and the second power voltage PAM-vdd, so as to meet the transmission requirements of the power voltage PVDD and achieve the light emitting display function of the display panel 100.

In a second aspect, with reference to Fig. 17, an embodiment of the present application provides a display apparatus 200. The display apparatus 200 includes the display panel in any of the aforementioned embodiments.

It should be noted that the display apparatus 200 provided in the embodiment of the present application has the beneficial effects of the display panel in any of the aforementioned embodiments, specifically referring to the aforementioned description of the beneficial effects of the display panel, which will not be repeated by the embodiments of the present application.

Although the disclosed embodiments of the present application are as described above, the described content is only for the purpose of easy understanding of the present application and is not intended to limit the present invention. Any person skilled in the art of the present application may make any modifications and changes in forms and details of implementation without departing from the scope disclosed in the present application, but the scope of protection of the present application shall still be subject to the scope defined in the appended claims.

Described above are only the specific embodiments of the present application, and those skilled in the art can clearly understand that, for the convenience and conciseness of the description, the replacement of other connections described above and the like can refer to the corresponding processes in the foregoing method embodiments, and will not be repeated here. It should be understood that the protection scope of the present application is not limited thereto. A person skilled in the art can readily conceive various equivalent modifications or replacements within the technical scope disclosed by the present application, and these modifications or replacements shall fall within the protection scope of the present application.

## Claims

1. A display panel (100) comprising a plurality of pixel circuits (P) which comprise a plurality of transistors (M), the display panel (100) further comprising:
a substrate (10);
a first organic layer (20) disposed on a side of the substrate (10); and
a first metal layer (30) disposed on a side of the first organic layer (20) away from the substrate (10), the first metal layer (30) comprising a first conductor portion (31), the first conductor portion (31) on the substrate (10) overlapping at least partially with an orthographic projection of at least one of the transistors (M) of the pixel circuits (P) on the substrate (10),
wherein the first conductor portion (31) comprises first openings (32), orthographic projections of the first openings (32) on the substrate (10) overlapping at least partially with an orthographic projection of the first organic layer (20) on the substrate (10).

2. The display panel (100) according to claim 1, wherein orthographic projections of at least part of the first openings (32) on the substrate (10) overlap at least partially with orthographic projections of the transistors (M) in the pixel circuits (P) on the substrate (10); and/or
the orthographic projections of at least part of the first openings (32) on the substrate (10) are located outside an orthographic projection of any of the transistors (M) in the pixel circuits (P) on the substrate (10).

3. The display panel (100) according to claim 2, wherein the first openings (32) comprise a first type of openings (321) and a second type of openings (322), and the size of the first type of openings (321) is greater than that of the second type of openings (322).

4. The display panel (100) according to claim 3, wherein on a plane perpendicular to a plane where the display panel (100) is located, the first type of openings (321) do not overlap with the pixel circuits (P); and
on the plane perpendicular to the plane where the display panel (100) is located, at least part of the second type of openings (322) overlap with the pixel circuits (P).

5. The display panel (100) according to claim 3, wherein orthographic projections of the first type of openings (321) on the substrate (10) are located between orthographic projections of adjacent ones of the pixel circuits (P) on the substrate (10).

6. The display panel (100) according to claim 3, wherein adjacent ones of the pixel circuits (P) jointly form repeat circuit groups arranged repeatedly, wherein
adjacent ones of the repeat circuit groups are spaced apart to form spacer regions (J), and the first type of openings (321) are located in the spacer regions (J).

7. The display panel (100) according to claim 3, further comprising shift register units (V) located between adjacent ones of the pixel circuits (P), wherein
orthographic projections of the shift register units (V) on the substrate (10) overlap at least partially with orthographic projections of the first type of openings (321) on the substrate (10); and/or
orthographic projections of the shift register units (V) on the substrate (10) overlap at least partially with orthographic projections of the second type of openings (322) on the substrate (10).

8. The display panel (100) according to claim 1, wherein the first organic layer (20) comprises exhaust holes (21), and orthographic projections of the first openings (32) overlap at least partially with orthographic projections of the exhaust holes (21) on the substrate (10).

9. The display panel (100) according to claim 8, wherein the orthographic projections of the exhaust holes (21) on the substrate (10) are located within the orthographic projections of the first openings (32) on the substrate (10), and orthographic projection areas of the exhaust holes (21) on the substrate (10) are less than that of the first openings (32) on the substrate (10).

10. The display panel (100) according to claim 8, further comprising a first insulating layer (41) disposed on the side of the first metal layer (30) away from the substrate (10), wherein some structures in the first insulating layer (41) are located in the first openings (32) and the exhaust holes (21).

11. The display panel (100) according to claim 10, wherein the first insulating layer (41) is attached to a side wall of the first conductor portion (31) facing the first openings (32).

12. The display panel (100) according to claim 8, further comprising a second insulating layer (42) disposed between the first metal layer (30) and the first organic layer (20), wherein the second insulating layer (42) comprises second openings (421), and orthographic projections of the second openings (421) overlap with the orthographic projections of the exhaust holes (21) on the substrate (10).

13. The display panel (100) according to claim 1, further comprising a second metal layer (50) disposed on a side of the substrate (10), wherein the second metal layer (50) comprises a second conductor portion (51), an orthographic projection of the second conductor portion (51) on the substrate (10) overlapping at least partially with orthographic projections of at least part of the first openings (32) on the substrate (10).

14. The display panel (100) according to claim 13, further comprising a first active layer (61) disposed on a side of the second metal layer (50) facing the substrate (10), wherein the first active layer (61) comprises a first active structure (611) comprising first exposed portions (612), orthographic projections of the first exposed portions (612) on the substrate (10) are located within the first openings (32), and the orthographic projection of the second conductor portion (51) on the substrate (10) overlaps at least partially with the orthographic projections of the first exposed portions (612) on the substrate (10).

15. The display panel (100) according to claim 14, wherein the second metal layer (50) is located on the side of the first metal layer (30) facing the substrate (10), the display panel (100) further comprises a second active layer (62) disposed between the second metal layer (50) and the first metal layer (30), the second active layer (62) comprising a second active structure (621), and an orthographic projection of the second active structure (621) on the substrate (10) is located outside the orthographic projections of the first openings (32) on the substrate (10).

16. The display panel (100) according to claim 14, wherein the second metal layer (50) is disposed on the side of the first metal layer (30) away from the substrate (10).

17. The display panel (100) according to claim 16, further comprising a second active layer (62) disposed between the first metal layer (30) and the first active layer (61), wherein the second active layer (62) comprises a second active structure (621) comprising second exposed portions (622), orthographic projections of the second exposed portions (622) on the substrate (10) are located within the first openings (32), and the orthographic projection of the second conductor portion (51) on the substrate (10) overlaps at least partially with the orthographic projections of the second exposed portions (622) on the substrate (10).

18. The display panel (100) according to claim 16, wherein orthographic projections of first openings (32) overlapping at least partially with the first active structure (611) overlap at least partially with the orthographic projection of the second conductor portion (51) on the substrate (10).

19. The display panel (100) according to claim 1, further comprising a second metal layer (50) disposed on a side of the first metal layer (30) away from the substrate (10), wherein the second metal layer (50) comprises a second conductor portion (51) comprising a third type of openings (52) and a fourth type of openings (53), and the size of the third type of openings (52) is greater than that of the fourth type of openings (53).

20. The display panel (100) according to claim 19, wherein the first conductor portion (31) transmits different signals from those the second conductor portion (51) transmits.

21. The display panel (100) according to claim 20, wherein the pixel circuits (P) comprise a pulse amplitude modulation circuit (P2) and a pulse width modulation circuit (P1), the pulse amplitude modulation circuit (P2) being configured to control an amplitude of a driving current based on applied pulse amplitude modulation data, and the pulse width modulation circuit (P1) being configured to control a pulse width of the driving current;
the pulse width modulation circuit (P1) comprises a first power terminal configured for providing a first power voltage, and the first conductor portion (31) transmits the first power voltage; and
the pulse amplitude modulation circuit (P2) comprises a second power terminal configured for providing a second power voltage, and the second conductor portion (51) transmits the second power voltage.

22. The display panel (100) according to claim 19, wherein in a direction perpendicular to the plane where the display panel (100) is located, the third type of openings (52) do not overlap with the pixel circuits (P), and/or the fourth type of openings (53) overlap at least partially with the pixel circuits (P).

23. The display panel (100) according to claim 22, wherein an orthographic projection of one of the third type of openings (52) on the substrate (10) is located between orthographic projections of two of the pixel circuits (P) adjacent to the one of the third type of openings (52) on the substrate (10).

24. The display panel (100) according to claim 23, wherein the second conductor portion (51) comprises a first pad (54) and a second pad (55) that are insulated, the second pad (55) being connected to the pixel circuits (P); and
the first pad (54) comprises the fourth type of openings (53), and/or the second pad (55) comprises the fourth type of openings (53).

25. The display panel (100) according to claim 24, wherein the size of the fourth type of openings (53) on the first pad (54) is greater than that of the fourth type of openings (53) on the second pad (55).

26. The display panel (100) according to claim 25, wherein the first pad (54) comprises the fourth type of ring-shaped openings, and the second pad (55) comprises the fourth type of ring-shaped openings, and
wherein the third type of openings (52) are disposed on the first pad (54) and spaced apart from the fourth type of ring-shaped openings.

27. The display panel (100) according to claim 19, wherein the first openings (32) comprise the first type of openings (321) and the second type of openings (322), and the size of the first type of openings (321) is greater than that of the second type of openings (322);
on the plane perpendicular to the plane where the display panel (100) is located, the first type of openings (321) do not overlap with the pixel circuits (P);
on the plane perpendicular to the plane where the display panel (100) is located, at least part of the second type of openings (322) overlap with the pixel circuits (P); and
on the plane perpendicular to the plane where the display panel (100) is located, at least part of the second type of openings (322) do not overlap with the fourth type of openings (53), and/or at least part of the first type of openings (321) do not overlap with the third type of openings (52).

28. The display panel (100) according to claim 27, wherein orthographic projections of part of the second type of openings (322) on the substrate (10) are located between orthographic projections of adjacent ones of the pixel circuits (P) on the substrate (10), and the orthographic projections of openings of the second type (322) on the substrate (10) overlap at least partially with an orthographic projection of one of the third type of openings (53) on the substrate (10); and/or
orthographic projections of part of the fourth type of openings (53) on the substrate (10) are located between orthographic projections of adjacent ones of the pixel circuits (P) on the substrate (10), and the orthographic projections of openings of the fourth type (53) on the substrate (10) overlap at least partially with an orthographic projection of one of the first type of openings (321) on the substrate (10).

29. The display panel (100) according to claim 27, wherein in a region between adjacent ones of the pixel circuits (P), the orthographic projections of the second type of openings (322) on the substrate (10) overlap at least partially with the orthographic projections of the fourth type of openings (53) on the substrate (10).

30. The display panel (100) according to claim 1, wherein the first conductor portion (31) comprises first sub portions (311) and second sub portions (312) adjacent to each other in a first direction (X) on two sides of the first openings (32), the first sub portion (311) and the second sub portion (312) transmit a same signal, and the first direction (X) is parallel to the plane where the substrate (10) is located.

31. The display panel (100) according to claim 30, wherein the first sub portions (311) and the second sub portions (312) are connected into a whole.

32. The display panel (100) according to claim 31, wherein the first metal layer (30) further comprises conductive portions extending in the first direction (X), orthographic projections of the conductive portions on the substrate (10) being located within the first openings (32), and the conductive portions connecting the first sub portions (311) with the second sub portions (312).

33. The display panel (100) according to claim 1, wherein the pixel circuit (P) comprises a pulse amplitude modulation circuit (P2) and a pulse width modulation circuit (P1), the pulse amplitude modulation circuit (P2) being configured to control an amplitude of a driving current based on applied pulse amplitude modulation data, and the pulse width modulation circuit (P1) being configured to control a pulse width of the driving current; and
the pulse width modulation circuit (P1) comprises a first power terminal configured for providing a first power voltage, and the first conductor portion (31) transmits the first power voltage, and/or the pulse amplitude modulation circuit (P2) comprises a second power terminal configured for providing a second power voltage, and the first conductor portion (31) transmits the second power voltage.

34. A display apparatus (200), comprising the display panel (100) according to any one of claims 1 to 33.
